# EUROPEAN PATENT APPLICATION

(11) **EP 4 761 494 A2**
(43) Date of publication of application: **17.06.2026**
(21) Application number: 25214581.8
(22) Date of filing: 10.11.2025
(51) Int. Cl.: H10B 12/00

(54) **SEMICONDUCTOR DEVICE AND METHOD FOR FABRICATING THE SAME**

(30) Priority: 13.12.2024 KR 20240185930
(71) Applicant: SK hynix Inc., Bubal-eub Icheon-si Gyeonggi-do 17336 (KR)
(72) Inventor: KWAK, Jun Ha, 17336 Icheon-si, Gyeonggi-do (KR); CHOI, Kang Sik, 17336 Icheon-si, Gyeonggi-do (KR); KIM, Jung Nam, 17336 Icheon-si, Gyeonggi-do (KR); SEO, Jung Won, 17336 Icheon-si, Gyeonggi-do (KR)
(74) Representative: Isarpatent

(57) **Abstract**

A semiconductor device including high-integrated memory cells and a method for fabricating the semiconductor device are provided. The method for fabricating a semiconductor device includes forming an alternating stack of sacrificial pad sheets and inter-pad dielectric layers, which are stacked vertically spaced apart from each other over a substrate; forming preliminary contact holes penetrating the alternating stack; forming sacrificial plugs filling the preliminary contact holes; performing post-treatment processes on the sacrificial plugs and forming sacrificial plug patterns having different heights and sacrificial recesses having different depths; forming contact liner layers on sidewalls of the sacrificial recesses; removing the sacrificial plug patterns and forming contact holes; forming contact plugs filling the contact holes; removing the sacrificial pad sheets and forming pad openings; and forming each pad of a plurality of pads in a different one of the pad openings.

## Description

### BACKGROUND

### 1. Field

Various embodiments of the present disclosure relate generally to a semiconductor device, and more particularly, to a semiconductor device including three-dimensional (3D) memory cells, and a method for fabricating the semiconductor device.

### 2. Description of the Related Art

Recently, in order to cope with the large capacity and miniaturization of a memory device, a three-dimensional (3D) memory device in which a plurality of memory cells are stacked has been proposed.

### SUMMARY

Embodiments of the present disclosure are directed to a semiconductor device including high-integrated memory cells, and a method for fabricating the semiconductor device.

In accordance with an embodiment of the present disclosure, a method for fabricating a semiconductor device may include forming an alternating stack of sacrificial pad sheets and inter-pad dielectric layers, which are stacked vertically spaced apart from each other over a substrate; forming preliminary contact holes penetrating the alternating stack; forming sacrificial plugs filling the preliminary contact holes; performing post-treatment processes on the sacrificial plugs and forming sacrificial plug patterns having different heights and sacrificial recesses having different depths; forming contact liner layers on sidewalls of the sacrificial recesses; removing the sacrificial plug patterns and forming contact holes; forming contact plugs filling the contact holes; removing the sacrificial pad sheets and forming pad openings; and forming each pad of a plurality of pads in a different one of the pad openings.

In accordance with an embodiment of the present disclosure, a method for fabricating a semiconductor device may include forming a first alternating stack including horizontal conductive lines over a substrate; forming a second alternating stack of sacrificial pad sheets and inter-pad dielectric layers, the second alternating stack being horizontally spaced apart from the first alternating stack; forming preliminary contact holes penetrating the second alternating stack; forming sacrificial plugs filling the preliminary contact holes; performing post-treatment processes on the sacrificial plugs and forming sacrificial plug patterns having different heights and sacrificial recesses having different depths; forming contact liner layers on sidewalls of the sacrificial recesses; removing the sacrificial plug patterns and forming contact holes; forming contact plugs filling the contact holes; removing the sacrificial pad sheets and forming pad openings that expose ends of the horizontal conductive lines; and forming pads each coupled to a different one of the horizontal conductive lines in the pad openings.

In accordance with an embodiment of the present disclosure, a semiconductor device may include a lower structure; a cell array region including a plurality of horizontal conductive lines each having a gate-all-around structure, which are vertically stacked in a first direction over the lower structure; a coupling region including a stack of a plurality of pads each coupled to a different one of the horizontal conductive lines and having the same horizontal length; and a plurality of contact structures coupled to the pads.

These and other features and advantages of the embodiments of the present disclosure will become apparent to those skilled in the art from the following detailed description in conjunction with the following drawings.

### BRIEF DESCRIPTION OF THE DRAWINGS

FIG. 1A is a schematic perspective view illustrating a memory cell in accordance with an embodiment of the present disclosure.
FIG. 1B is a schematic cross-sectional view of the memory cell illustrated in FIG. 1A.
FIG. 2A is a schematic view illustrating a semiconductor device in accordance with an embodiment of the present disclosure.
FIG. 2B is a schematic perspective view illustrating a memory cell array illustrated in FIG. 2A.
FIG. 2C is an equivalent circuit view illustrating a column array illustrated in FIG. 2B.
FIG. 2D is an equivalent circuit view illustrating a row array illustrated in FIG. 2B.
FIG. 3 is a schematic plan view illustrating a semiconductor device in accordance with an embodiment of the present disclosure.
FIG. 4A is a detailed plan view illustrating a memory cell array illustrated in FIG. 3.
FIG. 4B is a cross-sectional view of the memory cell array taken along line A-A' illustrated in FIG. 4A.
FIG. 4C is a cross-sectional view of the semiconductor device taken along line B1-B1' illustrated in FIG. 3.
FIGS. 5A to 23B illustrate various views of a semiconductor device formed utilizing a method for fabricating the semiconductor device in accordance with an embodiment of the present disclosure.
FIG. 24 is a plan view illustrating the semiconductor device for illustrating a method for fabricating a coupling region.
FIGS. 25 to 43 are cross-sectional views of the semiconductor device taken along line B1-B1' illustrated in FIG. 24 to describe the method for fabricating the coupling region.

### DETAILED DESCRIPTION

Various embodiments of the present disclosure may be described with reference to cross-sectional views, plan views and block diagrams, which are ideal schematic views of a semiconductor device. It is noted that the structures of the drawings may be modified by fabricating techniques and/or tolerances. The embodiments of the present disclosure are not limited to the described embodiments and the specific structures illustrated in the drawings, but may include other embodiments, or modifications of the described embodiments including any changes in the structures that may be produced according to requirements of the fabricating process. Accordingly, the regions illustrated in the drawings have schematic attributes, and the shapes of the regions illustrated in the drawings are intended to illustrate specific structures of regions of the elements and are not intended to limit the scope of the present disclosure.

The following embodiment relates to three-dimensional memory cells, in which memory cells are vertically stacked to increase memory cell density and reduce parasitic capacitance.

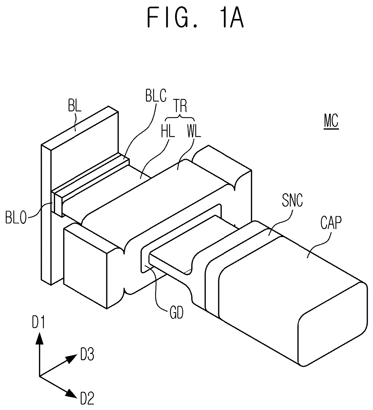

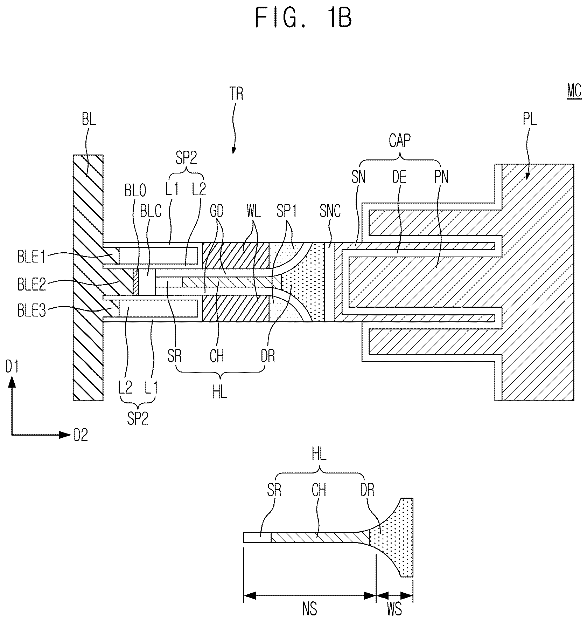

FIG. 1A is a schematic perspective view illustrating a memory cell MC in accordance with an embodiment of the present disclosure. FIG. 1B is a schematic cross-sectional view of the memory cell MC illustrated in FIG. 1A.

Referring to FIGS. 1A and 1B, the memory cell MC may include a first conductive line BL, a switching element TR, and a data storage element CAP, with the switching element TR operatively coupled between the first conductive line BL and the data storage element CAP.

The first conductive line BL may be vertically oriented in a first direction D1. The first conductive line BL may include a bit line. The first conductive line BL may be referred to as a "vertical conductive line", a "vertically-oriented bit line", a "vertical-extending bit line", or a "pillar-shaped bit line". The first conductive line BL may include a conductive material. The first conductive line BL may include a silicon-based material, a metal-based material, or a combination thereof. The first conductive line BL may include polysilicon, metal, metal nitride, metal silicide, or a combination thereof. The first conductive line BL may include polysilicon, titanium nitride, tungsten, or a combination thereof. For example, the first conductive line BL may include a titanium nitride/tungsten stack (TiN/W) in which titanium nitride and tungsten are sequentially stacked.

The switching element TR has a function of controlling voltage or current supply to the data storage element CAP during a data write operation and/or a data read operation performed on the data storage element CAP. The switching element TR may include a nano sheet HL, a nano sheet dielectric layer GD, and a second conductive line WL. The second conductive line WL may include a horizontal conductive line or a horizontal word line, and the nano sheet HL may include an active layer. The switching element TR may include a transistor, and in this case, the second conductive line WL may serve as a gate electrode. The switching element TR may also be referred to as a "nano sheet transistor", a "cell transistor", an "access element" or a "selection element". The second conductive line WL may be referred to as a "horizontal gate electrode" or a "horizontal word line".

The nano sheet HL may extend in a second direction D2 that intersects with the first direction D1. The second conductive line WL may extend in a third direction D3 that intersects with the first direction D1 and the second direction D2. The first direction D1 may be a vertical direction, the second direction D2 may be a first horizontal direction, and the third direction D3 may be a second horizontal direction. The nano sheet HL may extend in the first horizontal direction, i.e., the second direction D2, and the second conductive line WL may extend in the second horizontal direction, i.e., the third direction D3. The nano sheet HL may be referred to as a "horizontal layer".

The nano sheet HL may include a channel CH, a first doped region SR between the channel CH and the first conductive line BL, and a second doped region DR between the channel CH and the data storage element CAP. The first doped region SR may be coupled to the first conductive line BL, and the second doped region DR may be coupled to the data storage element CAP. A height of the second doped region DR in the first direction D1 may be greater than a height of the channel CH in the first direction D1. A length of the second doped region DR in the second direction D2 may be less than a length of the channel CH in the second direction D2. The lengths of the first doped region SR, the channel CH and the second doped region DR in the third direction D3 may be equal to one another.

The nano sheet HL may include a first sheet region NS and a second sheet region WS that are horizontally disposed adjacent to each other in the second direction D2. The second sheet region WS may extend from the first sheet region NS. The second sheet region WS may have a thickness that gradually increases in the second direction D2 from one end thereof where it contacts the first sheet region NS toward a second end thereof where it contacts the data storage element CAP. The second sheet region extends between the first sheet region NS and the data storage element CAP. An average vertical height or thickness of the second sheet region WS in the first direction D1 may be greater than an average vertical height or thickness of the first sheet region NS. Hereinafter, the first sheet region NS is referred to as a "narrow sheet", and the second sheet region WS is referred to as a "wide sheet".

The narrow sheet NS may have a flat plate shape. The wide sheet WS may have a fan-like shape. The wide sheet WS may have a thickness that gradually increases in the second direction D2. The narrow sheet NS may be referred to as a "flat plate-shaped sheet", and the wide sheet WS may be referred to as a "fan-like shaped sheet". A boundary portion between the narrow sheet NS and the wide sheet WS may have a curvature.

The first doped region SR and the channel CH may be disposed in the narrow sheet NS, and the second doped region DR may be disposed in the wide sheet WS. The channel CH formed in the narrow sheet NS may be referred to as a "narrow channel" or a "flat channel". A portion of the second doped region DR may extend to be disposed in the narrow sheet NS. The second doped region DR may include a thick portion disposed in the wide sheet WS and a thin portion disposed in the narrow sheet NS. One side of the wide sheet WS and one side of the second doped region DR, which contact the data storage element CAP, may each have a flat side shape.

A horizontal length of the wide sheet WS in the second direction D2 may be less than a horizontal length of the narrow sheet NS in the second direction D2. The narrow sheet NS may be referred to as a "long sheet", and the wide sheet WS may be referred to as a "short sheet".

The nano sheet HL may include a semiconductive material. For example, the nano sheet HL may include polysilicon, monocrystalline silicon, germanium, or silicon-germanium. In some embodiments, the nano sheet HL may include an oxide semiconductor material. For example, the oxide semiconductor material may include indium gallium zinc oxide (IGZO), indium tin zinc oxide (InSnZnO), zinc tin oxide (ZnSnO), or a combination thereof. In some embodiments, the nano sheet HL may include a conductive metal oxide. In some embodiments, the nano sheet HL may include a two-dimensional material, for example, molybdenum disulfide (MoS₂) tungsten disulfide (WS₂), or molybdenum diselenide (MoSe₂).

When the nano sheet HL is formed of the oxide semiconductor material, the channel CH may also be formed of the oxide semiconductor material, and the first and second doped regions SR and DR may be omitted. The nano sheet HL may also be referred to as an "active layer" or a "thin body".

The first doped region SR and the second doped region DR may be doped with the same conductivity type of an impurity. Each of the first doped region SR and the second doped region DR may be doped with an N-type conductive impurity or a P-type conductive impurity. The first doped region SR and the second doped region DR may include at least one impurity selected from among arsenic (As), phosphorus (P), boron (B), indium (In), and combinations thereof. The first doped region SR may be coupled to the first conductive line BL, and the second doped region DR may be coupled to the data storage element CAP. The first and second doped regions SR and DR may be referred to as "first and second source/drain regions".

The nano sheet HL may be horizontally oriented in the second direction D2 from the first conductive line BL. The second conductive line WL may have a gate-all-around (GAA) structure. For example, the second conductive line WL may surround the nano sheet HL and extend in the third direction D3. The nano sheet dielectric layer GD may be formed between the nano sheet HL and the second conductive line WL. The nano sheet dielectric layer GD may surround the nano sheet HL. The second conductive line WL may surround the nano sheet HL on the nano sheet dielectric layer GD.

The second conductive line WL may include a metal-based material, a semiconductive material, or a combination thereof. The second conductive line WL may include molybdenum, molybdenum nitride, ruthenium, titanium nitride, tungsten, polysilicon, or a combination thereof. For example, the second conductive line WL may include a TiN/W stack in which titanium nitride and tungsten are sequentially stacked. The second conductive line WL may include an N-type work function material or a P-type work function material. The N-type work function material may have a low work function of approximately 4.5 eV or less, and the P-type work function material may have a high work function of approximately 4.5 eV or greater. The second conductive line WL may include a stack of a low work function material and a high work function material.

The nano sheet dielectric layer GD may be disposed between the nano sheet HL and the second conductive line WL. The nano sheet dielectric layer GD may be referred to as a "gate dielectric layer" or a "channel-side dielectric layer". The nano sheet dielectric layer GD may include silicon oxide, silicon nitride, metal oxide, metal oxide nitride, metal silicate, a high-k material, a ferroelectric material, an anti-ferroelectric material, or a combination thereof. The nano sheet dielectric layer GD may include silicon dioxide (SiO₂), silicon nitride (Si₃N₄), hafnium dioxide (HfO₂), aluminum oxide (Al₂O₃), zirconium dioxide (ZrO₂), aluminum oxynitride (AlON), hafnium oxynitride (HfON), hafnium silicon oxide (HfSiO), hafnium silicon oxynitride (HfSiON), hafnium zirconium oxide (HfZrO), or a combination thereof. The nano sheet dielectric layer GD may be formed by a thermal oxidation process of a semiconductive material.

The data storage element CAP may include a memory element such as a capacitor. The data storage element CAP may be horizontally disposed in the second direction D2 from the switching element TR. The data storage element CAP may include a first electrode SN, a second electrode PN on the first electrode SN, and a dielectric layer DE between the first electrode SN and the second electrode PN. The first electrode SN may horizontally extend in the second direction D2 from the nano sheet HL. The first electrode SN, the dielectric layer DE and the second electrode PN may be horizontally disposed in the second direction D2. The first electrode SN may include an inner space and a plurality of outer surfaces, and the inner space of the first electrode SN may include a plurality of inner surfaces. The outer surfaces of the first electrode SN may include a vertical outer surface and a plurality of horizontal outer surfaces. The vertical outer surface of the first electrode SN may vertically extend in the first direction D1, and the horizontal outer surfaces of the first electrode SN may horizontally extend in the second direction D2 or the third direction D3. The inner space of the first electrode SN may be a three-dimensional space. The dielectric layer DE may conformally cover the inner surfaces of the first electrode SN. The second electrode PN may be disposed in the inner space of the first electrode SN on the dielectric layer DE. Some of the outer surfaces of the first electrode SN may be electrically coupled to the second doped region DR of the nano sheet HL. The second electrode PN of the data storage element CAP may be coupled to a common plate PL.

The data storage element CAP may have a three-dimensional structure. The first electrode SN may have a three-dimensional structure, which may have a horizontal three-dimensional structure that is oriented in the second direction D2. In an example of the three-dimensional structure, the first electrode SN may have a cylindrical shape. The cylindrical shape of the first electrode SN may include cylindrical inner surfaces and cylindrical outer surfaces. Some of the cylindrical outer surfaces of the first electrode SN may be electrically coupled to the second doped region DR of the nano sheet HL. The dielectric layer DE and the second electrode PN may be disposed on the cylindrical inner surfaces of the first electrode SN.

In some embodiments, the first electrode SN may have a pillar shape or a pylinder shape. The pylinder shape refers to a structure in which a pillar shape and a cylindrical shape are merged.

The first electrode SN and the second electrode PN may include metal, noble metal, metal nitride, conductive metal oxide, conductive noble metal oxide, metal carbide, metal silicide, or a combination thereof. For example, the first electrode SN and the second electrode PN may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/ titanium nitride (TiSiN/TiN) stack, or a combination thereof. The second electrode PN may also include a combination of a metal-based material and a silicon-based material. For example, the second electrode PN may be a titanium nitride/silicon germanium/tungsten nitride (TiN/SiGe/WN) stack. In the titanium nitride/silicon germanium/tungsten nitride (TiN/SiGe/WN) stack, silicon germanium may be a gap-fill material that fills the inside of the first electrode SN, titanium nitride (TiN) may serve as the second electrode PN of the data storage element CAP, and tungsten nitride may be a low-resistance material.

The dielectric layer DE may be referred to as a "capacitor dielectric layer" or a "memory layer". The dielectric layer DE may include silicon oxide, silicon nitride, a high-k material, a perovskite material, or a combination thereof. The high-k material may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅) or strontium titanium oxide (SrTiO₃). In some embodiments, the dielectric layer DE may be formed of a composite layer including two or more layers of the above-described high-k material. The dielectric layer DE may be formed of zirconium (Zr)-based oxide. The dielectric layer DE may have a stack structure containing zirconium oxide (ZrO₂). The dielectric layer DE may include a ZA (ZrO₂/Al₂O₃) stack or a ZAZ (ZrO₂/Al₂O₃/ZrO₂) stack. The ZA stack may have a structure in which aluminum oxide (Al₂O₃) is stacked on zirconium oxide (ZrO₂). The ZAZ stack may have a structure in which zirconium oxide (ZrO₂), aluminum oxide (Al₂O₃) and zirconium oxide (ZrO₂) are sequentially stacked. Each of the ZA stack and the ZAZ stack may be referred to as a "zirconium oxide (ZrO₂)-based layer". In some embodiments, the dielectric layer DE may be formed of hafnium (Hf)-based oxide. The dielectric layer DE may have a stack structure containing hafnium oxide (HfO₂). The dielectric layer DE may include an HA (HfO₂/Al₂O₃) stack or an HAH (HfO₂/Al₂O₃/HfO₂) stack. The HA stack may have a structure in which aluminum oxide (Al₂O₃) is stacked on hafnium oxide (HfO₂). The HAH stack may have a structure in which hafnium oxide (HfO₂), aluminum oxide (Al₂O₃) and hafnium oxide (HfO₂) are sequentially stacked. Each of the HA stack and the HAH stack may be referred to as a "hafnium oxide (HfO₂)-based layer". In the ZA stack, ZAZ stack, HA stack and HAH stack, aluminum oxide (Al₂O₃) may have a greater band gap energy than zirconium oxide (ZrO₂) and hafnium oxide (HfO₂). Aluminum oxide (Al₂O₃) may have a lower dielectric constant than zirconium oxide (ZrO₂) and hafnium oxide (HfO₂). Accordingly, the dielectric layer DE may include a stack of a high-k material and a high band gap material having a greater band gap energy than the high-k material. The dielectric layer DE may include silicon oxide (SiO₂) as a high band gap material other than aluminum oxide (Al₂O₃). Because the dielectric layer DE includes a high band gap material, leakage current may be suppressed. The high band gap material may be thinner than the high-k material. In some embodiments, the dielectric layer DE may include a stack structure in which a high-k material and a high band gap material are alternately stacked. For example, the dielectric layer DE may include a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HAHA (HfO₂/Al₂O₃/HfO₂/Al₂O₃) stack, a HAHAH (HfO₂/Al₂O₃/HfO₂/Al₂O₃/HfO₂) stack, a HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, a HZHZ (HfO₂/ZrO₂/HfO₂/ZrO₂) stack, or an AHZAZHA (Al₂O₃/HfO₂/ZrO₂/Al₂O₃/ZrO₂/HfO₂/Al₂O₃) stack. In the above-described stack structures, the aluminum oxide (Al₂O₃) may be thinner than the zirconium oxide (ZrO₂) and the hafnium oxide (HfO₂).

In some embodiments, the dielectric layer DE may include a high-k material and a high band gap material. The dielectric layer DE may have a laminated structure in which a plurality of high-k materials and a plurality of high band gap materials are stacked or an intermixed structure in which a high-k material and a high band gap material are intermixed.

In some embodiments, the dielectric layer DE may include a ferroelectric material, an anti-ferroelectric material, or a combination thereof. For example, the dielectric layer DE may include HfZrO.

In some embodiments, the dielectric layer DE may include a combination of a high-k material and a ferroelectric material, a combination of a high-k material and an anti-ferroelectric material, or a combination of a high-k material or a ferroelectric material and an anti-ferroelectric material.

In some embodiments, an interface control layer may be further formed between the first electrode SN and the dielectric layer DE to alleviate leakage current. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode PN and the dielectric layer DE.

The data storage element CAP may include a three-dimensional capacitor. The data storage element CAP may include a Metal-Insulator-Metal (MIM) capacitor. The data storage element CAP may be replaced with another data storage material. For example, the data storage material may be a thyristor, a phase-change material, a Magnetic Tunnel Junction (MTJ), or a variable resistance material.

The memory cell MC may further include a first contact node BLC and a second contact node SNC. The first contact node BLC may be disposed between the first conductive line BL and the nano sheet HL. The first contact node BLC may include a metal-based material or a semiconductive material. For example, the first contact node BLC may include titanium, titanium nitride, tungsten, or a combination thereof. In addition, the first contact node BLC may include doped silicon, and the first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped silicon, and the second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of the channel CH in the first direction D1.

The nano sheet HL may include a first edge and a second edge. The first edge refers to a portion of the first doped region SR electrically coupled to the first conductive line BL, and the second edge refers to a portion of the second doped region DR electrically coupled to the first electrode SN of the data storage element CAP.

The memory cell MC may further include an ohmic contact layer BLO between the first contact node BLC and the first conductive line BL. The ohmic contact layer BLO may include, for example, metal silicide.

The memory cell MC may further include a first spacer SP1 and a second spacer SP2. The first spacer SP1 may be disposed between the second conductive line WL and the second doped region DR. The second spacer SP2 may be disposed between the first conductive line BL and the second conductive line WL. The second spacer SP2 may include a stack of a first liner L1 and a second liner L2. The first and second spacers SP1 and SP2 may each include a dielectric material. The first and second spacers SP1 and SP2 may each include, for example, silicon oxide, silicon nitride, or a combination thereof. The first spacer SP1 may include, for example, silicon nitride. In an embodiment, the first liner L1 of the second spacer SP2 may be silicon nitride, whereas the second liner L2 of the second spacer SP2 may be silicon oxide. The second liner L2 may partially fill an inner space of the first liner L1.

The first conductive line BL may include a plurality of spaced apart horizontal extension portions BLE1, BLE2, and BLE3. The horizontal extension portions BLE1, BLE2, and BLE3 may each extend in the second direction D2. The horizontal extension portions may include an inner horizontal extension portion BLE2 and outer horizontal extension portions BLE1 and BLE3. The inner horizontal extension portion BLE2 of the first conductive line BL may extend to be disposed in a gap between the first liners L1 which are vertically adjacent to each other. Accordingly, the inner horizontal extension portion BLE2 of the first conductive line BL may be electrically coupled to the ohmic contact layer BLO.

The outer horizontal extension portions BLE1 and BLE3 of the first conductive line BL may extend to be disposed in one side of the second spacer SP2. Accordingly, the outer horizontal extension portions BLE1 and BLE3 of the first conductive line BL may contact the second liner L2 of the second spacer SP2.

In an embodiment, the second contact node SNC may be selectively grown from the wide sheet WS of the nano sheet HL. The second contact node SNC may be formed by selective epitaxial growth (SEG). For example, the second contact node SNC may be a silicon epitaxial layer formed by the SEG. For example, the second contact node SNC may be a doped silicon epitaxial layer.

In some embodiments, the first contact node BLC may also be selectively grown from the narrow sheet NS of the nano sheet HL. The first contact node BLC may be formed by selective epitaxial growth (SEG). For example, the first contact node BLC may be a silicon epitaxial layer formed by the SEG. The first contact node BLC may be a doped silicon epitaxial layer.

The first contact node BLC may be a narrow sheet-side contact node, and the second contact node SNC may be a wide sheet-side contact node.

From another perspective, the memory cell MC may include the switching element TR and the data storage element CAP. A gate of the switching element TR may be coupled to the second conductive line WL, the first doped region SR of the switching element TR may be coupled to the first conductive line BL, and the second doped region DR of the switching element TR may be coupled to the data storage element CAP.

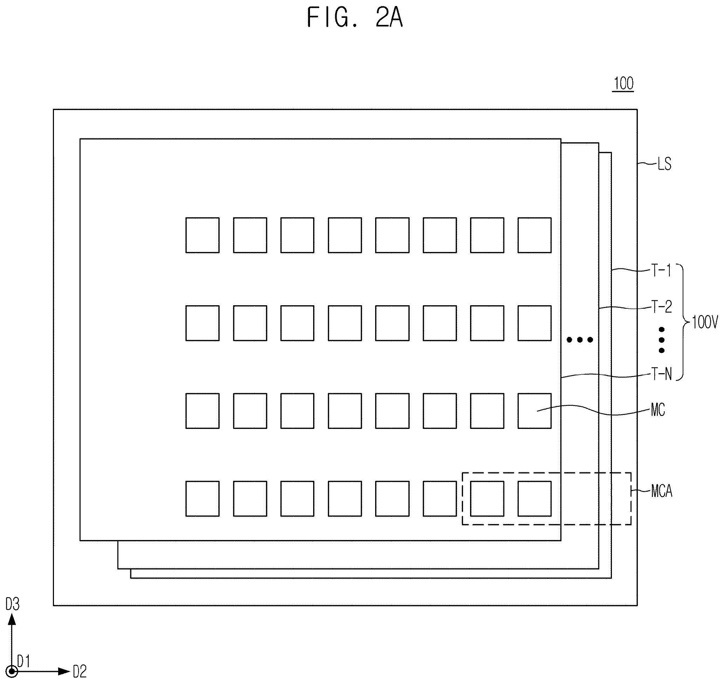

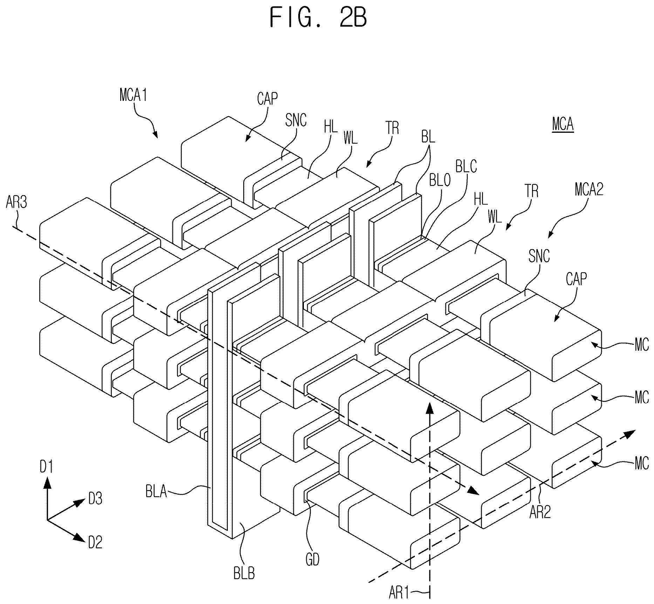

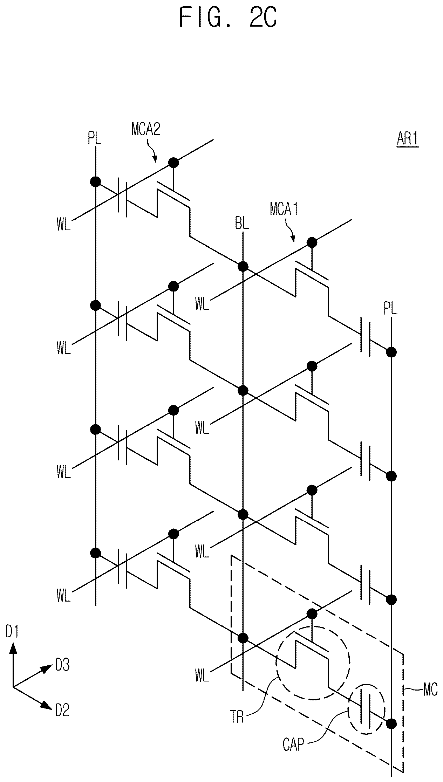

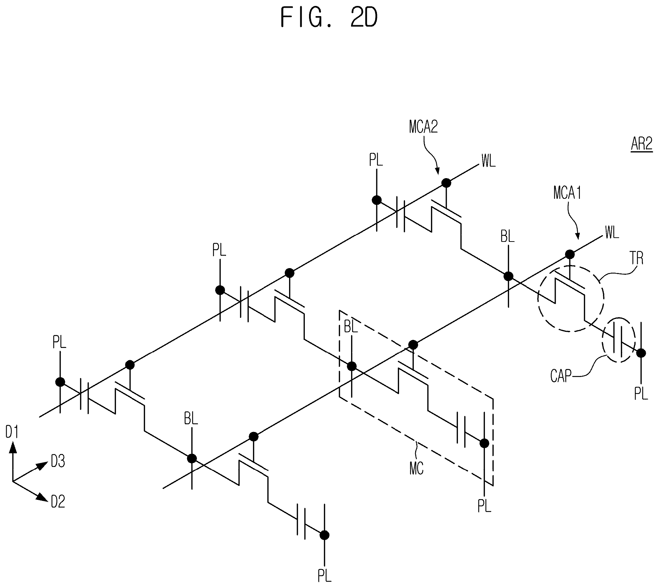

FIG. 2A is a schematic view illustrating a semiconductor device 100 in accordance with an embodiment of the present disclosure. FIG. 2B is a schematic perspective view illustrating a memory cell array MCA illustrated in FIG. 2A. FIG. 2C is an equivalent circuit view illustrating a column array AR1 illustrated in FIG. 2B. FIG. 2D is an equivalent circuit view illustrating a row array AR2 illustrated in FIG. 2B.

Referring to FIG. 2A, the semiconductor device 100 may include a plurality of planes T-1 to T-N. The planes T-1 to T-N may constitute a vertical stack 100V. Each of the planes T-1 to T-N may include a plurality of memory cells MC. The vertical stack 100V may include a memory cell array MCA. The memory cell array MCA may include a three-dimensional array of the memory cells MC. Detailed components of the memory cells MC are described above with reference to FIGS. 1A and 1B.

Referring to FIGS. 2B to 2D, the memory cell array MCA may include the plurality of memory cells MC vertically stacked in a first direction D1. The memory cell array MCA may further include a plurality of memory cells MC horizontally disposed in a second direction D2. The memory cell array MCA may further include a plurality of memory cells MC horizontally disposed in a third direction D3.

Each of the memory cells MC may include a first conductive line BL, a switching element TR, and a data storage element CAP. The switching element TR may disposed between the first conductive line BL and the data storage element CAP. The switching element TR may include a second conductive line WL, a nano sheet dielectric layer GD, and a nano sheet HL.

The memory cell array MCA may include a column array AR1 of the memory cells MC and a row array AR2 of the memory cells MC. The column array AR1 may include the plurality of memory cells MC vertically stacked in the first direction D1. The memory cells MC in the column array AR1 may share the first conductive line BL. The row array AR2 may include the plurality of memory cells MC horizontally disposed in the third direction D3. The memory cells MC in the row array AR2 may share the second conductive line WL. The first direction D1 may be a vertical direction, and the third direction D3 may be a horizontal direction. The memory cell array MCA may further include a horizontal level array AR3. The horizontal level array AR3 may include the plurality of memory cells MC disposed at the same horizontal level in the second direction D2. Neighboring memory cells MC in the horizontal level array AR3 may share the first conductive line BL.

The memory cell array MCA may include a first sub-cell array MCA1 and a second sub-cell array MCA2. The first and second sub-cell arrays MCA1 and MCA2 may each include a three-dimensional array of the memory cells MC. The first and second sub-cell arrays MCA1 and MCA2 may share the first conductive line BL. The first conductive line BL may include a first vertical conductive line BLA and a second vertical conductive line BLB. A bottom portion of the first vertical conductive line BLA and a bottom portion of the second vertical conductive line BLB may be merged with each other. The first conductive line BL may have a U-shape formed by merging the first vertical conductive line BLA and the second vertical conductive line BLB. The memory cells MC of the first sub-cell array MCA1 may share the first vertical conductive line BLA, and the memory cells MC of the second sub-cell array MCA2 may share the second vertical conductive line BLB. In this way, the neighboring first and second sub-cell arrays MCA1 and MCA2 may have a mirror-type structure of sharing the first conductive line BL. From the perspective of a top view, the first and second vertical conductive lines BLA and BLB may each have a rectangular shape.

Referring back to FIG. 2A, a lower structure LS may be disposed at a lower level than the memory cell array MCA. The lower structure LS may include a semiconductor substrate, a metal interconnection structure, a dielectric structure, a conductive structure, a bonding pad structure, another memory, or a peripheral circuit portion. For example, the lower structure LS may include a structure in which the peripheral circuit portion, the metal interconnection structure and the bonding pad structure are sequentially stacked. The memory cell array MCA and the peripheral circuit portion of the lower structure LS may be bonded, for example, by wafer bonding. The wafer bonding may include pad bonding, hybrid bonding, oxide-to-oxide bonding, metal-to-metal bonding, or a combination thereof.

The peripheral circuit portion of the lower structure LS may be disposed at a lower level than the memory cell array MCA. This structure may be referred to as a "cell array over PERI (COP) structure" or a "PERI under cell array (PUC) structure". The peripheral circuit portion may include at least one control circuit for driving the memory cell array MCA. At least one control circuit of the peripheral circuit portion may include an N-channel transistor, a P-channel transistor, a CMOS circuit, or a combination thereof. At least one control circuit of the peripheral circuit portion may include an address decoder circuit, a read circuit, or a write circuit. At least one control circuit of the peripheral circuit portion may include a planar channel transistor, a recess channel transistor, a buried gate transistor, or a fin channel transistor (FinFET). For example, the peripheral circuit portion may include sub-word line drivers and a sense amplifier. The first conductive line BL may be coupled to the sense amplifier, whereas the second conductive lines WL may be coupled to the sub-word line drivers.

In some embodiments, the peripheral circuit portion may be disposed at a higher level than the memory cell array MCA. This structure may be referred to as a "PERI over cell array (POC) structure" or a "cell array under PERI (CUP) structure".

In some embodiments, the memory cell array MCA may include a DRAM, an embedded DRAM, a NAND, a FeRAM, a STT-RAM, a PCRAM, or a ReRAM.

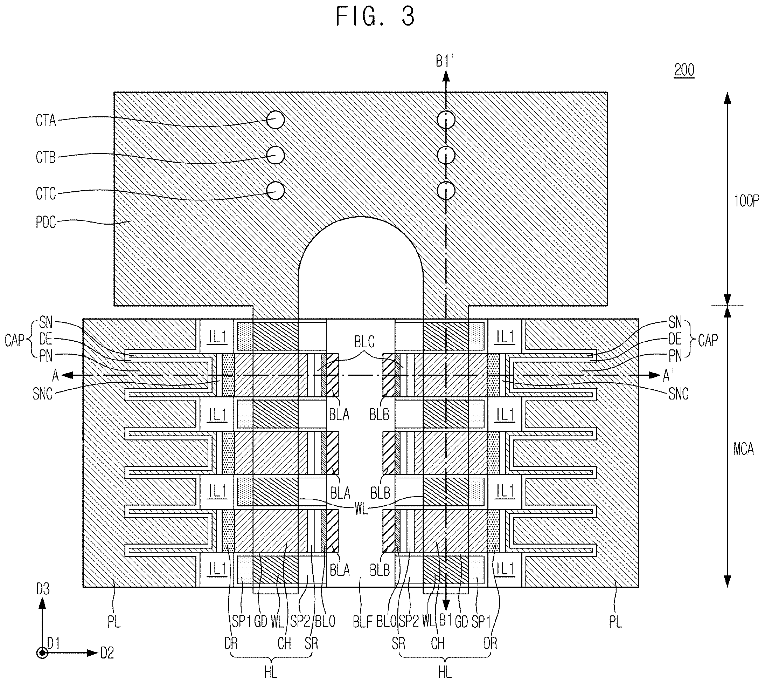

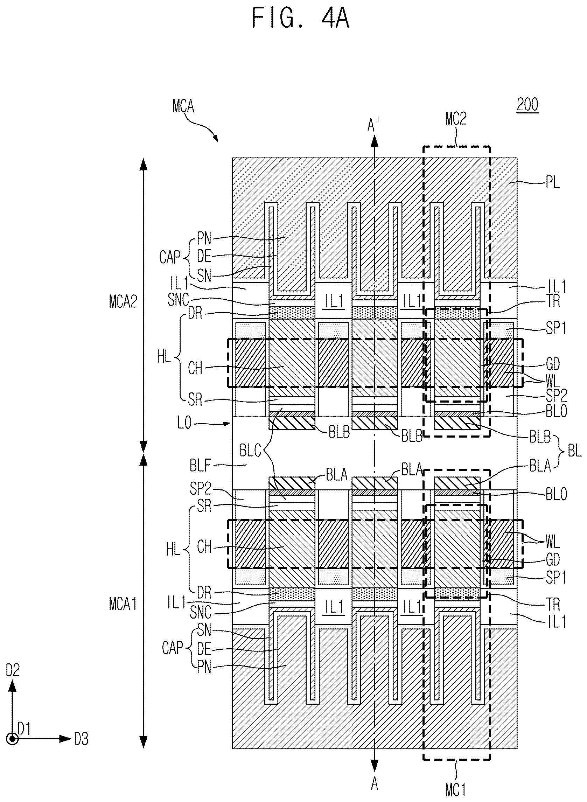

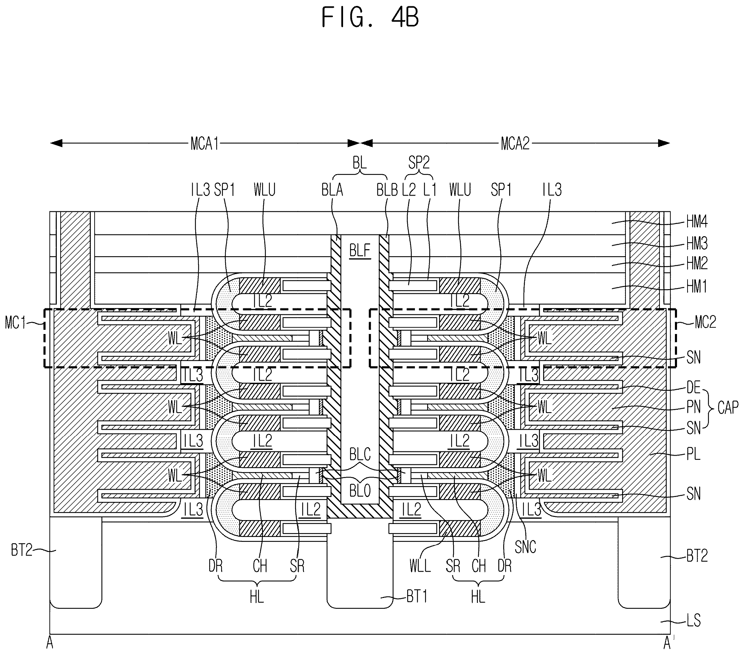

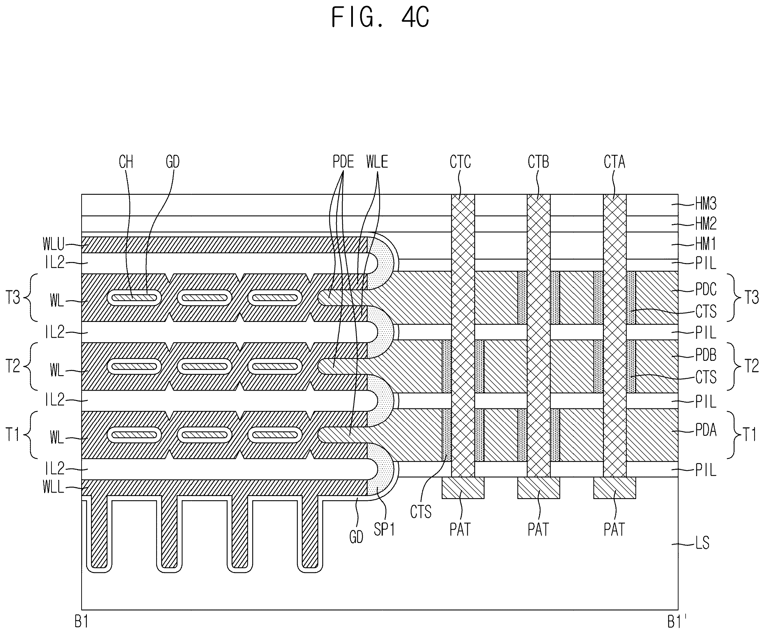

FIG. 3 is a schematic plan view illustrating a semiconductor device 200 in accordance with an embodiment of the present disclosure. FIG. 3 illustrates an example of the row array AR2 of FIG. 2B. FIG. 4A is a detailed plan view illustrating a memory cell array MCA illustrated in FIG. 3. FIG. 4B is a cross-sectional view of the memory cell array MCA taken along line A-A' illustrated in FIG. 4A. FIG. 4C is a cross-sectional view of the semiconductor device 200 taken along line B1-B1' illustrated in FIG. 3.

The semiconductor device 200 illustrated in FIGS. 3 to 4C may be similar to the memory cell array MCA illustrated in FIGS. 2A to 2D. Hereinafter, detailed descriptions of overlapping components may be omitted.

Referring to FIGS. 3, 4A, 4B and 4C, the semiconductor device 200 may include a memory cell array MCA and a coupling region 100P. The coupling region 100P may include pads PDA, PDB and PDC of multi-layer levels T1, T2 and T3. The pads PDA, PDB and PDC may be electrically coupled to contact plugs CTA, CTB and CTC, respectively. The contact plugs CTA, CTB and CTC may pass through all of the pads PDA, PDB and PDC. A first contact plug CTA and a first pad PDA may be electrically coupled to each other. The first contact plug CTA and second and third pads PDB and PDC may be electrically decoupled from each other by contact spacers CTS. A second contact plug CTB and the second pad PDB may be electrically coupled to each other, and the second contact plug CTB and the first and third pads PDA and PDC may be electrically decoupled from each other by the contact spacers CTS. A third contact plug CTC and the third pad PDC may be electrically coupled to each other, and the third contact plug CTC and the first and second pads PDA and PDB may be electrically decoupled from each other by the contact spacers CTS. A pad dielectric layer PIL may be disposed between the pads PDA, PDB and PDC. Each of dielectric stoppers PAT may be disposed below bottom portions of the contact plugs CTA, CTB and CTC. The coupling region 100P may have a step-less structure.

The memory cell array MCA may include a three-dimensional array of memory cells MC1 and MC2. The memory cell array MCA may include a first sub-cell array MCA1 and a second sub-cell array MCA2. The coupling region 100P may be referred to as a "pad region". The coupling region 100P may include the pads PDA, PDB and PDC of the multi-levels.

The memory cell array MCA may include a plurality of memory cells MC1 and MC2 vertically stacked in a first direction D1. Each of the memory cells MC1 and MC2 may have the same configuration as the memory cell MC described with reference to FIGS. 1A and 1B. The memory cell array MCA may include the plurality of memory cells MC1 and MC2 horizontally disposed in a second direction D2. The memory cell array MCA may include the plurality of memory cells MC1 and MC2 horizontally disposed in a third direction D3. The memory cell array MCA may include a plurality of first conductive lines BL. Each of the first conductive lines BL may include a first vertical conductive line BLA and a second vertical conductive line BLB. A bottom portion of the first vertical conductive line BLA and a bottom portion of the second vertical conductive line BLB may be merged with each other.

Each of the first memory cells MC1 of the first sub-cell array MCA1 may include the first vertical conductive line BLA, a switching element TR, and a data storage element CAP. The switching element TR of the first memory cell MC1 may include a second conductive line WL and a nano sheet HL. Each of the second memory cells MC2 of the second sub-cell array MCA2 may include the second vertical conductive line BLB, a switching element TR, and a data storage element CAP. The switching element TR of the second memory cell MC2 may include a second conductive line WL and a nano sheet HL. The switching elements TR of the first and second memory cells MC1 and MC2 may be nano sheet transistors.

The first conductive line BL may vertically extend in the first direction D1. The nano sheet HL may extend in the second direction D2. The second conductive line WL may horizontally extend in the third direction D3.

A first inter-cell dielectric layer IL1 may be disposed between the data storage elements CAP disposed adjacent to each other in the third direction D3. A second inter-cell dielectric layer IL2 may be disposed between the second conductive lines WL vertically stacked in the first direction D1. A third inter-cell dielectric layer IL3 may be disposed between first electrodes SN of the data storage elements CAP vertically stacked in the first direction D1. The first to third inter-cell dielectric layers IL1, IL2 and IL3 may each include, for example, silicon oxide, silicon carbon oxide (SiCO), silicon nitride, or a combination thereof. The first inter-cell dielectric layer IL1 may be referred to as a "device isolation layer".

Each of the first and second memory cells MC1 and MC2 may further include a first contact node BLC and a second contact node SNC. The first contact node BLC may be disposed between the first conductive lines (BLA and BLB) and the nano sheet HL. The first contact node BLC may include a metal-based material or a semiconductive material. For example, the first contact node BLC may include titanium, titanium nitride, tungsten, or a combination thereof. In addition, the first contact node BLC may include doped polysilicon, and a first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped polysilicon, and a second doped region DR may include an impurity diffused from the second contact node SNC. A height of the first contact node BLC in the first direction D1 may be less than a height of the second contact node SNC in the first direction D1. A height of the first contact node BLC in the first direction D1 may be greater than a height of a channel CH in the first direction D1.

Each of the first and second memory cells MC1 and MC2 may further include an ohmic contact layer BLO between the first contact node BLC and the first conductive line BL. The ohmic contact layer BLO may include, for example, metal silicide.

Each of the first and second memory cells MC1 and MC2 may further include a first spacer SP1 and a second spacer SP2. The first spacer SP1 may be disposed between the second conductive line WL and the second doped region DR. The second spacer SP2 may be disposed between the first conductive line BL and the second conductive line WL. The second spacer SP2 may include a stack of a first liner L1 and a second liner L2. The first and second spacers SP1 and SP2 may each include a dielectric material. The first and second spacers SP1 and SP2 may each include, for example, silicon oxide, silicon nitride, or a combination thereof. The first spacer SP1 may include, for example, silicon nitride. The first liner L1 of the second spacer SP2 may be silicon nitride, and the second liner L2 of the second spacer SP2 may be silicon oxide. The first spacer SP1 may cover one side of the second inter-cell dielectric layer IL2. The first spacer SP1 may have a cup shape.

The memory cell array MCA may include a plurality of second conductive lines WL vertically stacked in the first direction D1. The memory cell array MCA may include a plurality of nano sheets HL vertically stacked in the first direction D1. The memory cell array MCA may include a plurality of data storage elements CAP vertically stacked in the first direction D1. The memory cell array MCA may include a plurality of first conductive lines BL spaced apart in the third direction D3. The memory cell array MCA may include dummy second conductive lines WLU disposed at a level higher than an uppermost second conductive line WL, and dummy second conductive lines WLL disposed at a level lower than a lowermost second conductive line WL. The dummy second conductive lines WLU and WLL may each have a linear shape extending horizontally.

The second conductive lines WL of the multi-layer levels T1, T2 and T3 may include extension portions WLE extending to the coupling region 100P, and edge portions PDE of the pads PDA, PDB and PDC may be disposed in inner spaces of the extension portions WLE. Each of the extension portions WLE of the second conductive lines WL may be electrically coupled to the pads PDA, PDB and PDC. The extension portions WLE may each have a concave shape, and the edge portions PDE of the pads PDA, PDB and PDC may each have a convex shape. The extension portions WLE and the edge portions PDE of the pads PDA, PDB and PDC may include different materials. The extension portions WLE and the edge portions PDE of the pads PDA, PDB and PDC may contact having a physical interface therebetween.

The memory cell array MCA may include a stack of a plurality of hard mask layers HM1, HM2, HM3 and HM4 disposed at a level higher than the uppermost second conductive line WL.

The memory cell array MCA may include a plurality of first and second bottom passivation layers BT1 and BT2. The first bottom passivation layer BT1 may prevent a bottom surface of the first conductive line BL and a lower structure LS from coming into electrical contact with each other. The second bottom passivation layer BT2 may prevent the data storage element CAP and the lower structure LS from coming into electrical contact with each other. Each of the first and second bottom passivation layers BT1 and BT2 may include a dielectric material.

A vertical isolation layer BLF may be disposed between the first vertical conductive line BLA and the second vertical conductive line BLB of the first conductive line BL. The vertical isolation layer BLF may include a dielectric material.

The nano sheets HL of the switching elements TR horizontally disposed in the third direction D3 may share one second conductive line WL. The nano sheets HL of the switching elements TR horizontally disposed in the third direction D3 may be coupled to different first conductive lines BL. The switching elements TR stacked in the first direction D1 may share one first conductive line BL. The switching elements TR horizontally disposed in the third direction D3 may share one second conductive line WL.

Second electrodes PN of the data storage elements CAP may be coupled to a common plate PL.

According to an embodiment, the semiconductor device 200 may include a column array and a row array of the nano sheets HL, the second conductive lines WL surrounding in common the nano sheets HL in the row array and each surrounding the nano sheets HL in the column array, the data storage elements CAP each coupled to the nano sheets HL in the column array and the row array, and the first conductive lines BL coupled in common to the nano sheets HL in the column array. Each of the first conductive lines BL may include the first vertical conductive line BLA and the second vertical conductive line BLB. The first vertical conductive line BLA and the second vertical conductive line BLB may be formed through a mask and etch process.

From another perspective, the semiconductor device 200 may include the first sub-cell array MCA1 including the first memory cells MC1 vertically stacked, the second sub-cell array MCA2 including the second memory cells MC2 vertically stacked, a linear opening (refer to reference symbol "LO" in FIG. 4A) between the first sub-cell array MCA1 and the second sub-cell array MCA2, and the first conductive line BL formed in the linear opening LO and electrically coupled to the first and second memory cells MC1 and MC2 horizontally disposed adjacent to each other.

From another perspective, the semiconductor device 200 may include the first conductive line BL vertically oriented in the first direction D1, and the data storage element CAP horizontally spaced apart from the first conductive line BL. Further, the semiconductor device 200 may include the nano sheet HL horizontally oriented in the second direction D2 perpendicular to the first direction D1 and including a first region NS contacting the first conductive line BL and a second region WS contacting the data storage element CAP. Furthermore, the semiconductor device 200 may include the second conductive line WL extending while surrounding the nano sheet HL in the third direction D3 perpendicular to the first and second directions D1 and D2.

From another perspective, the semiconductor device 200 may include a vertical stack including a column array AR1 of nano sheet transistors TR vertically stacked in the first direction D1. Each of the nano sheet transistors TR may include a flat plate-shaped narrow sheet NS and a fan-shaped wide sheet WS having a horizontal length less than the flat plate-shaped narrow sheet NS. Each of the nano sheet transistors TR may further include the nano sheet HL extending in the second direction D2 perpendicular to the first direction D1, and the second conductive line WL surrounding the flat plate-shaped narrow sheet NS and horizontally oriented in the third direction D3 perpendicular to the first and second directions D1 and D2.

From another perspective, the semiconductor device 200 may include a first column array MCA1 of nano sheet transistors TR vertically stacked in the first direction D1, a second column array MCA2 of the nano sheet transistors TR horizontally spaced apart from the first column array MCA1 and vertically stacked in the first direction D1, the vertical conductive line BL sharing the nano sheet transistors TR in the first column array MCA1 and the nano sheet transistors TR in the second column array MCA2 and extending in the first direction D1, and the data storage elements CAP each coupled to the nano sheet transistors TR in the first and second column arrays MCA1 and MCA2. Each of the nano sheet transistors TR may include a flat plate-shaped narrow sheet NA and a fan-shaped wide sheet WS having a horizontal length less than the flat plate-shaped narrow sheet NS. Each of the nano sheet transistors TR may further include the nano sheet HL extending in the second direction D2 perpendicular to the first direction D1, and the second conductive line WL surrounding the flat plate-shaped narrow sheet NS and horizontally oriented in the third direction D3 perpendicular to the first and second directions D1 and D2. The second conductive lines WL in the first and second column arrays MCA1 and MCA2 may surround the nano sheets HL disposed at the same horizontal level and extend in the third direction D3.

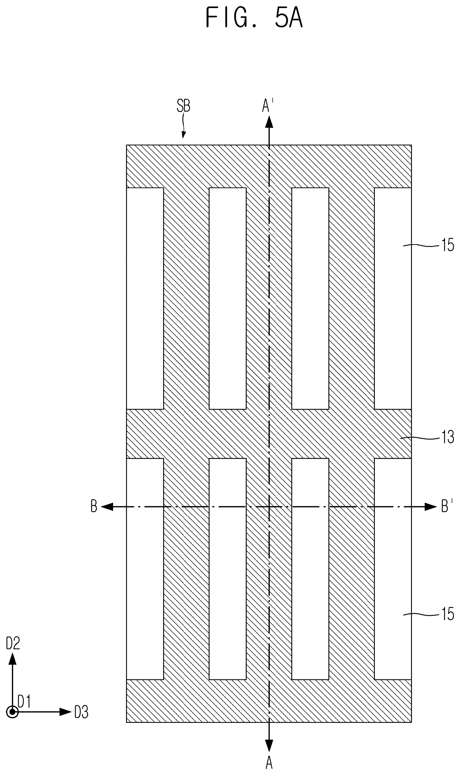

FIGS. 5A to 23B illustrate various views of a semiconductor device formed utilizing a method for fabricating the semiconductor device in accordance with an embodiment of the present disclosure.

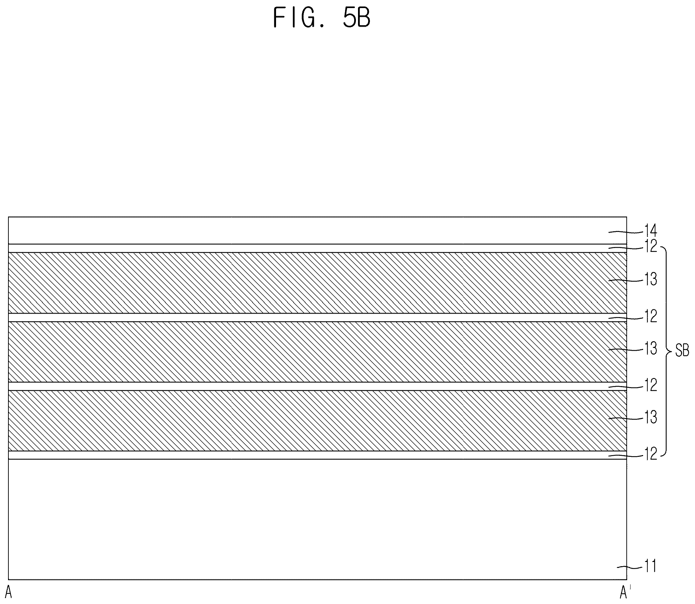

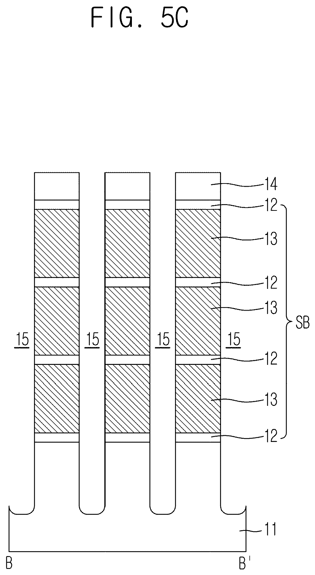

FIG. 5A is a plan view illustrating a structure at a second mold layer level for illustrating a method for forming a mold stack SB. FIG. 5B is a cross-sectional view of the structure taken along line A-A' illustrated in FIG. 5A. FIG. 5C is a cross-sectional view of the structure taken along line B-B' illustrated in FIG. 5A.

Referring to FIGS. 5A to 5C, the mold stack SB may be formed on a substrate 11. The mold stack SB may include an alternating stack of first mold layers 12 and second mold layers 13. To form the mold stack SB, the first mold layers 12 may be alternately stacked with the second mold layers 13, and the first mold layers 12 and the second mold layers 13 may be epitaxially grown multiple times. Alternating layers of the first mold layer 12 and the second mold layer 13 may be repeatedly grown to form multi-level tiers such as a first tier, a second tier, a third tier, ..., and an N^{th} tier in the mold stack SB. The first mold layer 12 may be disposed at the top of the mold stack SB.

The first mold layers 12 and the second mold layers 13 may be different semiconductive materials. The first mold layers 12 may each include silicon germanium or monocrystalline silicon germanium. The second mold layers 13 may each include monocrystalline silicon. The first mold layers 12 and the second mold layers 13 may be formed by an epitaxial growth process. A lowermost first mold layer 12 may serve as a seed layer during the epitaxial growth process. Each of the first mold layers 12 may be thinner than each of the second mold layers 13. The first mold layers 12 may include first epitaxially grown layers, and the second mold layers 13 may include second epitaxially grown layers.

In an embodiment, a plurality of monocrystalline silicon germanium layers may be alternately stacked with a plurality of monocrystalline silicon layers in the mold stack SB. For example, the first mold layers 12 may be the monocrystalline silicon germanium layers, and the second mold layers 13 may be the monocrystalline silicon layers. A stack of a monocrystalline silicon germanium layer and a monocrystalline silicon layer (a SiGe/Si stack) may be stacked multiple times. The first mold layers 12 may be referred to as "sacrificial layers", and the second mold layers 13 may be referred to as "nano sheet target layers" or "recess target layers".

The mold stack SB may be referred to as a "vertical stack". The mold stack SB may be formed by alternately stacking a plurality of sacrificial layers and a plurality of nano sheet target layers. The sacrificial layers may be monocrystalline silicon germanium layers, and the nano sheet target layers may be monocrystalline silicon layers.

A thickness ratio of the first mold layers 12 and the second mold layers 13 in the mold stack SB may be variously modified. For example, the thickness of the first mold layers 12 may be approximately 5 to 20 nm, and the thickness of the second mold layers 13 may be approximately 50 to 80 nm. A quantity of the first mold layers 12 and a quantity of the second mold layers 13 in the mold stack SB may be variously modified. In some embodiments, a triple stack including the first mold layer 12, the second mold layer 13 and the first mold layer 12 may be defined at lowermost and/or uppermost portions of the mold stack SB. The second mold layer 13 of the triple stack may have a thickness less than the second mold layer 13 of the mold stack SB.

A first hard mask layer 14 may be formed on the mold stack SB. The first hard mask layer 14 may include a dielectric material such as an oxide-based material, a nitride-based material, a carbon-based material, or a combination thereof. For example, the first hard mask layer 14 may include SiO₂, Si₃N₄, amorphous carbon, or a combination thereof.

Subsequently, portions of the mold stack SB may be etched using the first hard mask layer 14 as a barrier, and a plurality of sacrificial isolation openings 15 may be formed. The sacrificial isolation openings 15 may be initial openings for cell isolation. From the perspective of a top view, cross-sections of the sacrificial isolation openings 15 may each have a rectangular shape. In some embodiments, the cross-sections of the sacrificial isolation openings 15 may each have a circular shape or an oval shape. In some embodiments, the sacrificial isolation openings 15 may be referred to as "sacrificial isolation trenches". The sacrificial isolation openings 15 may vertically extend in a first direction D1 and extend lengthwise in a second direction D2. The sacrificial isolation openings 15 may be disposed at a predetermined interval in a third direction D3. A bottom surface of each of the sacrificial isolation openings 15 may extend inside of the substrate 11.

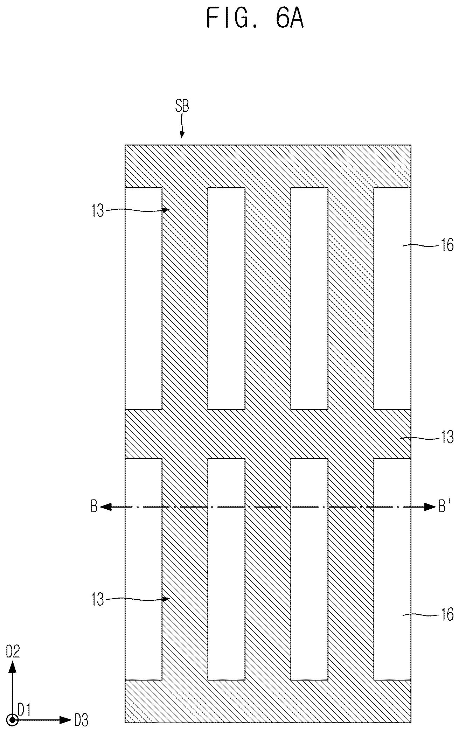

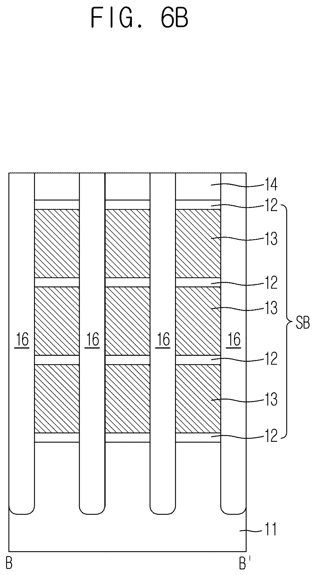

FIG. 6A is a plan view illustrating a structure at the second mold layer level for illustrating a method for forming sacrificial isolation layers 16, and FIG. 6B is a cross-sectional view of the structure taken along line B-B' illustrated in FIG. 6A.

Referring to FIGS. 6A and 6B, the sacrificial isolation layers 16 may be formed by filling the sacrificial isolation openings 15 with a dielectric material. The sacrificial isolation layers 16 may include the same dielectric material. The sacrificial isolation layers 16 may have an etch selectivity with respect to the mold stack SB. For example, in an embodiment, the sacrificial isolation layers 16 may each include silicon oxide, silicon nitride, silicon carbon oxide, silicon carbon nitride, or a combination thereof. Forming the sacrificial isolation layers 16 may include forming sacrificial isolation materials on the mold stack SB to fill the sacrificial isolation openings 15 followed by planarizing the sacrificial isolation materials so that a surface of the first hard mask layer 14 is exposed.

The sacrificial isolation layers 16 may extend vertically in the first direction D1 and lengthwise in the second direction D2. The sacrificial isolation layers 16 may also be disposed at a predetermined interval in the third direction D3. Each of the sacrificial isolation layers 16 may include a stack of a first sacrificial liner layer and a first sacrificial gap-fill layer. In an embodiment, the first sacrificial liner layer may be silicon nitride, and the first sacrificial gap-fill layer may be silicon oxide. The sacrificial isolation layers 16 may pass through the mold stack SB in the first direction D1.

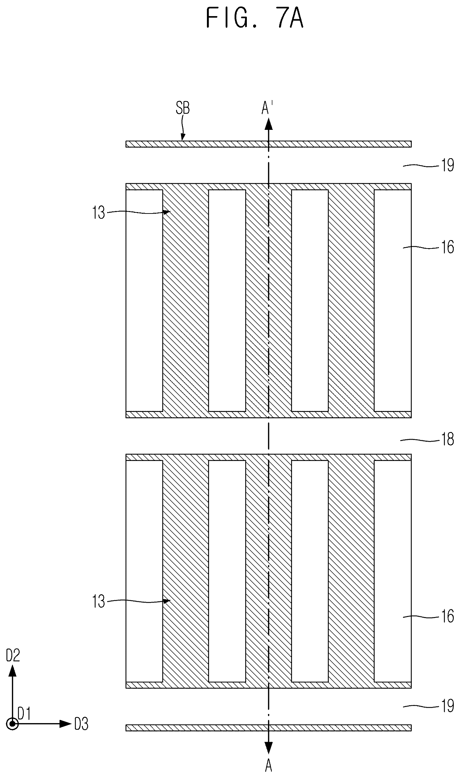

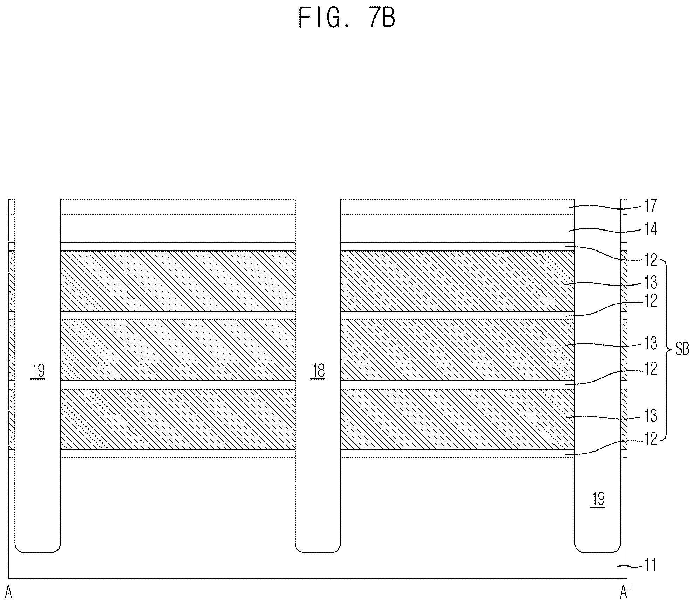

FIG. 7A is a plan view illustrating a structure at the second mold layer level for illustrating a method for forming sacrificial linear openings 18 and 19, and FIG. 7B is a cross-sectional view of the structure taken along line A-A' illustrated in FIG. 7A.

Referring to FIGS. 7A and 7B, a second hard mask layer 17 may be formed on the mold stack SB and the sacrificial isolation layers 16. The second hard mask layer 17 may include, for example, silicon nitride. The second hard mask layer 17 may be formed by etching a second hard mask material using a mask layer such as photoresist. The second hard mask layer 17 may have a plurality of line-shaped openings defined therein.

Portions of the mold stack SB may be etched using the second hard mask layer 17 as an etch barrier to form sacrificial linear openings 18 and 19 between the sacrificial isolation layers 16. The sacrificial linear openings may include a first sacrificial linear opening 18 and a second sacrificial linear opening 19. From the perspective of a top view, the first sacrificial linear opening 18 and the second sacrificial linear opening 19 may be line-shaped openings extending in the third direction D3. The first and second sacrificial linear openings 18 and 19 may each vertically extend in the first direction D1. The sacrificial isolation layers 16 may be disposed between the first and second sacrificial linear openings 18 and 19 in the second direction D2. From the perspective of a top view, cross sections of the first and second sacrificial linear openings 18 and 19 may each have a rectangular shape, however, the embodiments are not limited in this way. For example, in some embodiments, the cross sections of the first and second sacrificial linear openings 18 and 19 may each have a circular shape or an oval shape. The first and second sacrificial linear openings 18 and 19 may each have a width in the second direction D2 which is less than a width in the third direction D3. The first and second sacrificial linear openings 18 and 19 may be referred to as "sacrificial linear trenches". The sacrificial isolation layers 16 may not contact the first and second sacrificial linear openings 18 and 19.

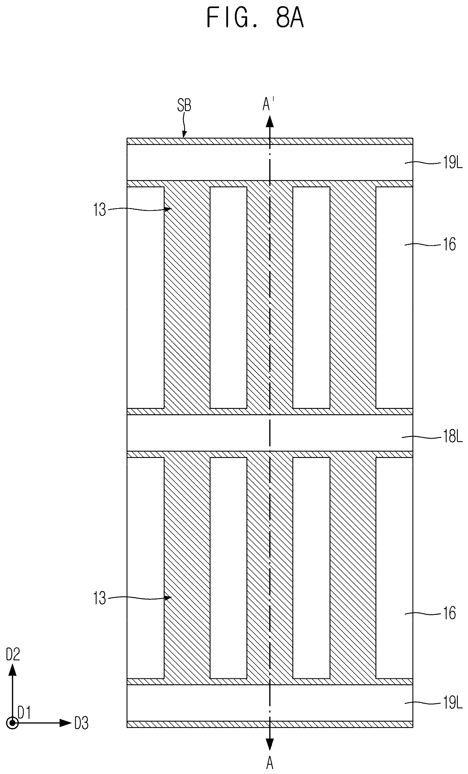

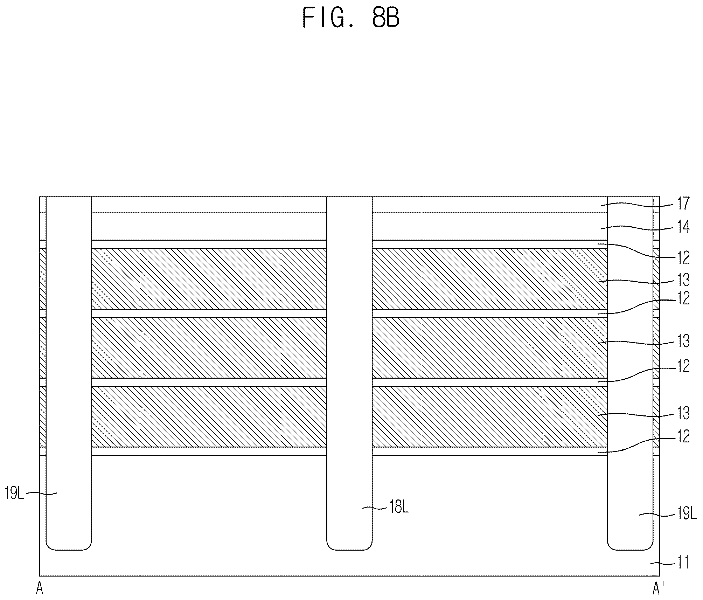

FIG. 8A is a plan view illustrating a structure at the second mold layer level for illustrating a method for forming linear sacrificial layers 18L and 19L, and FIG. 8B is a cross-sectional view of the structure taken along line A-A' illustrated in FIG. 8A.

Referring to FIGS. 8A and 8B, the linear sacrificial layers 18L and 19L may be formed by filling the first and second sacrificial linear openings 18 and 19. The linear sacrificial layers may include a first linear sacrificial layer 18L and a second linear sacrificial layer 19L. From the perspective of a top view, the first linear sacrificial layer 18L and the second linear sacrificial layer 19L may have line shapes extending in the third direction D3. The first and second linear sacrificial layers 18L and 19L may vertically extend in the first direction D1. The sacrificial isolation layers 16 may be disposed between the first and second linear sacrificial layers 18L and 19L in the second direction D2. From the perspective of a top view, cross sections of the first and second linear sacrificial layers 18L and 19L may each have a rectangular shape. However, the embodiments are not limited in this way and, in some embodiments, the cross-sections of the first and second linear sacrificial layers 18L and 19L may each have a circular shape or an oval shape. The first and second linear sacrificial layers 18L and 19L may include the same material. The first and second linear sacrificial layers 18L and 19L may each include a dielectric material. For example, the first and second linear sacrificial layers 18L and 19L may each include, for example, silicon oxide, silicon nitride, silicon carbon oxide, silicon carbon nitride, or a combination thereof. The sacrificial isolation layers 16 may not contact the first and second linear sacrificial layers 18L and 19L.

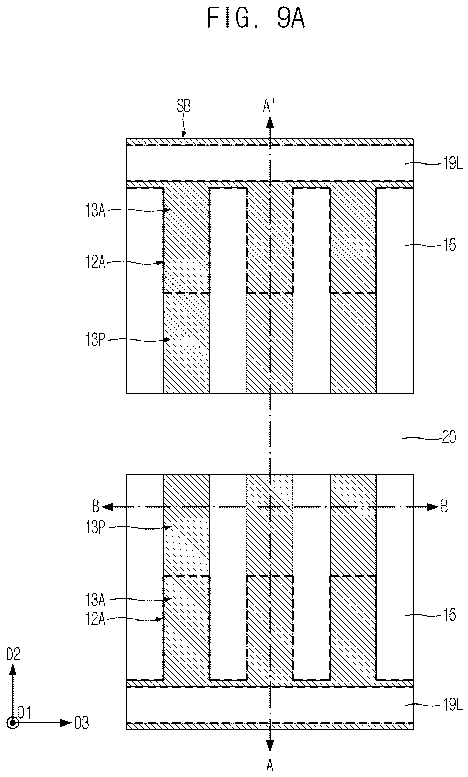

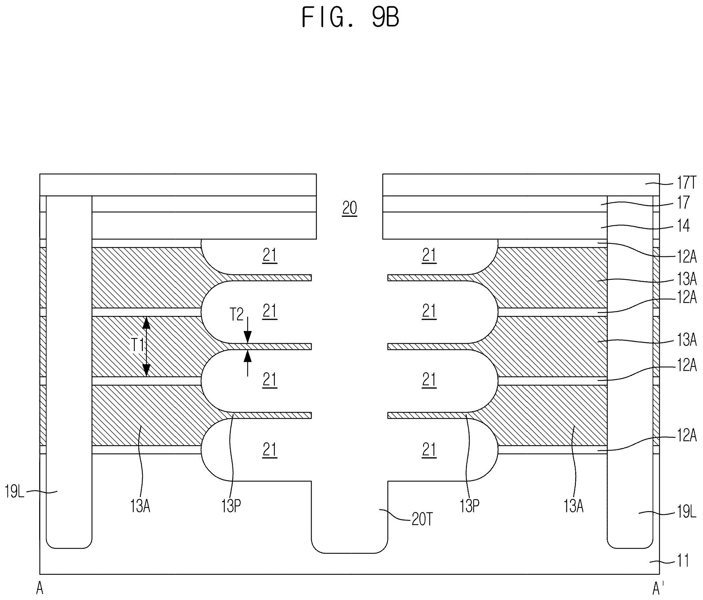

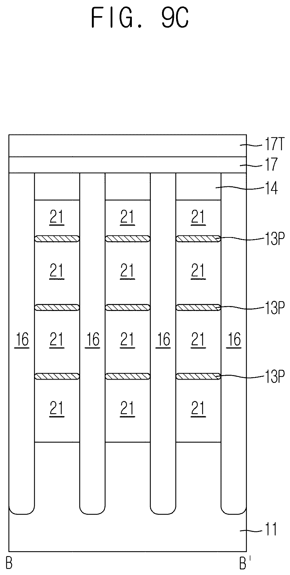

FIG. 9A is a plan view illustrating a structure at the second mold layer level to describe recessing of the second mold layers 12. FIG. 9B is a cross-sectional view of the structure taken along line A-A' illustrated in FIG. 9A. FIG. 9C is a cross-sectional view of the structure taken along line B-B' illustrated in FIG. 9A.

Referring to FIGS. 9A to 9C, among the first linear sacrificial layer 18L and the second linear sacrificial layer 19L, the first linear sacrificial layer 18L may be selectively removed to form a first linear opening 20. A third hard mask layer 17T may be used as an etch barrier to remove the first linear sacrificial layer 18L. From the perspective of a top view, the first linear opening 20 may be disposed horizontally spaced apart from the second linear sacrificial layer 19L in the second direction D2.

The first linear opening 20 may have the same size as or a size greater than the first sacrificial linear opening 18 described with reference to FIG. 7A. A bottom surface of a bottom portion 20T of the first linear opening 20 may be at the same level as a bottom surface of the first sacrificial linear opening 18. The bottom surface of the first linear opening 20 may be at the same level as the bottom surface of the sacrificial isolation layer 16.

The first and second mold layers 12 and 13 may be selectively recessed through the first linear openings 20.

A difference in etch selectivity between the first mold layers 12 and the second mold layers 13 may be used to selectively recess the first mold layers 12. The first mold layers 12 may be removed using a wet etch process or a dry etch process. For example, when the first mold layers 12 include silicon germanium layers, and the second mold layers 13 include monocrystalline silicon layers, the silicon germanium layers may be etched using an etchant or etch gas having a selectivity with respect to the monocrystalline silicon layers. The first mold layers each having an original thickness may remain as indicated by reference numeral "12A".

Subsequently, a portion (a first portion) of each of the second mold layers 13 may be recessed to form a narrow sheet 13P. A wet etch process or a dry etch process may be used to recess the second mold layers 13. An original body portion 13A and the narrow sheet 13P may be formed by the partial recessing of each of the second mold layers 13. The original body portion 13A may maintain an original thickness T1, while the narrow sheet 13P may have a thickness T2 less than the original thickness T1. A horizontal length of the original body portion 13A in the second direction D2 may be equal to or different from a horizontal length of the narrow sheet 13P in the second direction D2. A combination of the original body portion 13A and the narrow sheet 13P may be referred to as a "preliminary active layer". The narrow sheet 13P may be referred to as a "flat plate-shaped sheet" or a "protruding narrow sheet".

A recess process for forming the narrow sheet 13P may be referred to as a "thinning process" or "trimming process" of the second mold layer 13. To form the narrow sheet 13P, an upper surface, lower surface and side surface of the second mold layer 13 may be recessed. The narrow sheet 13P may be referred to as a "thin-body active layer". The narrow sheet 13P may include a monocrystalline silicon layer. The recess process for forming the narrow sheet 13P may use, for example, Hot SC-1 (HSC1). The HSC1 may include a solution in which ammonium hydroxide (NH₄OH), hydrogen peroxide (H₂O₂) and water (H₂O) are mixed in a ratio of 1:4:20. Using the HSC1, the second mold layers 13 may be selectively etched.

The narrow sheets 13P may be formed by the partial recess process for the second mold layers 13 as described above. An inter-nano sheet recess 21 may be formed between two narrow sheets 13P that are vertically disposed. Upper and lower surfaces of each of the narrow sheets 13P may each include a flat surface. A boundary portion between the original body portion 13A and the narrow sheet 13P may be vertical or have a curvature. Each of the first mold layers 12A may be disposed between two original body portions 13A that are vertically stacked.

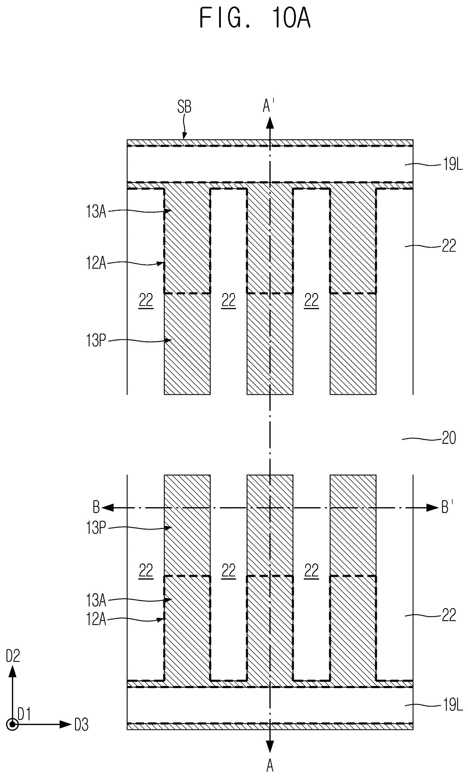

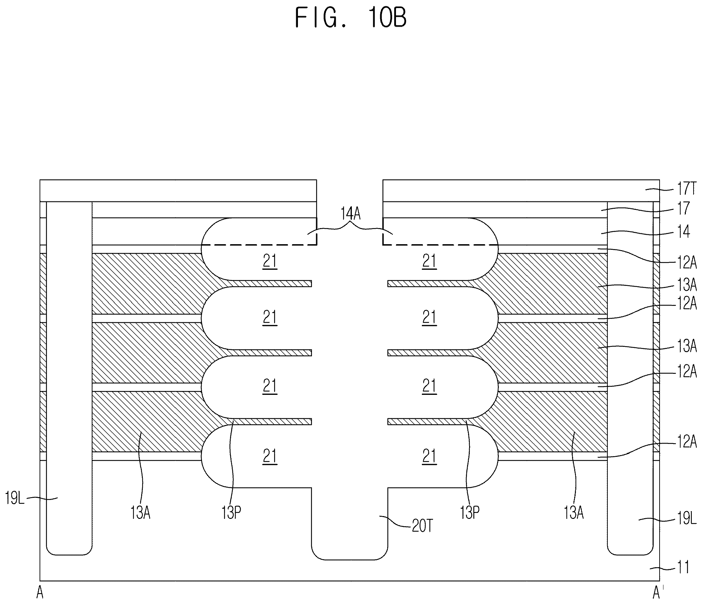

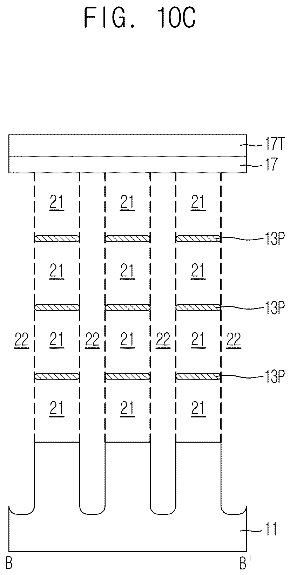

FIG. 10A is a plan view illustrating a structure at a narrow sheet level for illustrating a method for forming sacrificial isolation layer-level openings 22. FIG. 10B is a cross-sectional view of the structure taken along line A-A' illustrated in FIG. 10A. FIG. 10C is a cross-sectional view of the structure taken along line B-B' illustrated in FIG. 10A.

Referring to FIGS. FIGS. 10A to 10C, the sacrificial isolation layers 16 may be selectively stripped through the inter-nano sheet recesses 21 to form each of the sacrificial isolation layer-level openings 22 between the original body portions 13A in the third direction D3.

Side surfaces of the first mold layers 12A, side surfaces of the original body portions 13A and side surfaces of the narrow sheets 13P may be exposed in the third direction D3 by the sacrificial isolation layer-level openings 22.

While the sacrificial isolation layer-level openings 22 are formed, a portion of the first hard mask layer 14 (refer to reference numeral "14A" of FIG. 10B) may be recessed. Accordingly, a space of an uppermost inter-nano sheet recess 21 may be expanded.

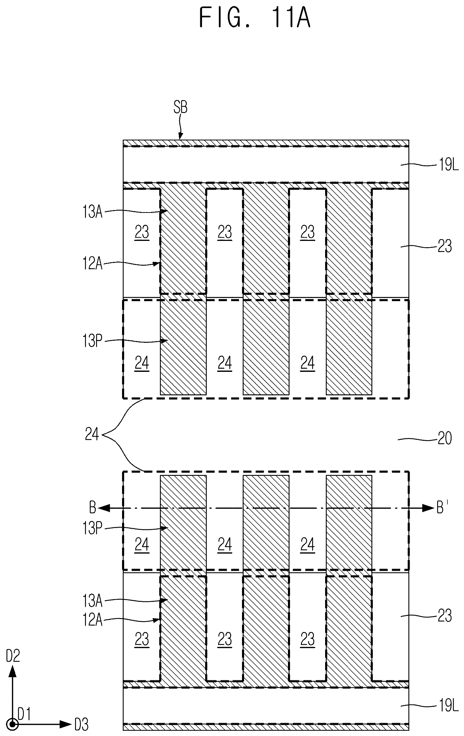

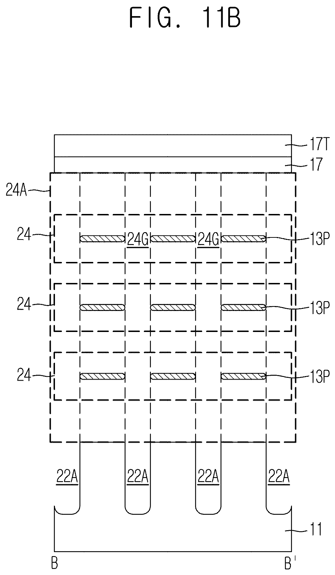

FIG. 11A is a plan view illustrating a structure at the narrow sheet level for illustrating a method for forming first inter-cell dielectric layers 23. FIG. 11B is a cross-sectional view of the structure taken along line B-B' illustrated in FIG. 11A.

Referring to FIGS. 11A and 11B, the first inter-cell dielectric layers 23 may be formed in the sacrificial isolation layer-level openings 22. The first inter-cell dielectric layers 23 may each include a dielectric material. The first inter-cell dielectric layers 23 may each include, for example, silicon oxide, silicon nitride, silicon carbon oxide, or a combination thereof. Forming the first inter-cell dielectric layers 23 may include forming a dielectric material that fills the sacrificial isolation layer-level openings 22 and performing an etch-back process on the dielectric material.

The first inter-cell dielectric layers 23 may fill portions of the sacrificial isolation layer-level openings 22. The side surfaces of the first mold layers 12A and the side surfaces of the original body portions 13A may be covered by the first inter-cell dielectric layers 23 in the third direction D3. The first inter-cell dielectric layers 23 may expose the side surfaces of the narrow sheets 13P. The other portions of the sacrificial isolation layer-level openings 22, i.e., non-gap-filled portions 22A, may expose the side surfaces of the narrow sheets 13P.

After the first inter-cell dielectric layers 23 are formed, then a nano sheet all-open recess 24A that opens all narrow sheets 13P may be formed. The nano sheet all-open recess 24A refers to a combination of the inter-nano sheet recesses 21 and the non-gap-filled portions 22A of the sacrificial isolation layer-level openings 22. The nano sheet all-open recess 24A may include a plurality of surrounding recesses 24. The surrounding recesses 24 may expose all narrow sheets 13P in the third direction D3. For example, one of the surrounding recesses 24 extending in the third direction D3 may surround all surfaces of the narrow sheets 13P at the same horizontal level. Each of the surrounding recesses 24 may include a plurality of initial gaps 24G. Each of the initial gaps 24G may be defined between the narrow sheets 13P in the third direction D3.

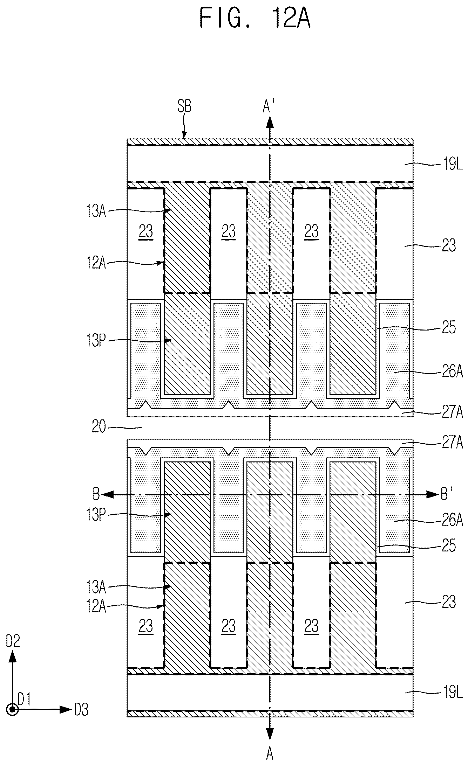

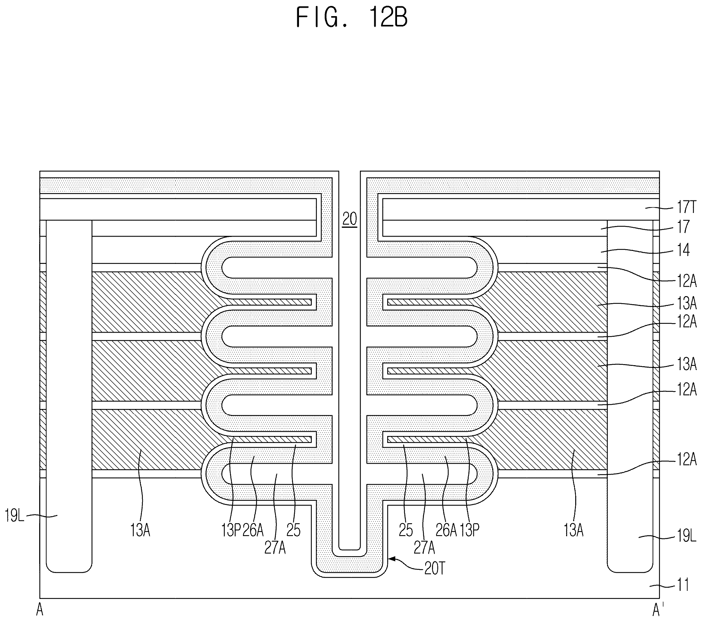

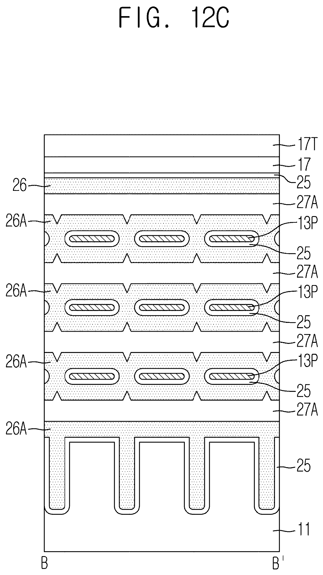

FIG. 12A is a plan view illustrating a structure at the narrow sheet level for illustrating a method for forming a first spacer layer 26A. FIG. 12B is a cross-sectional view of the structure taken along line A-A' illustrated in FIG. 12A. FIG. 12C is a cross-sectional view of the structure taken along line B-B' illustrated in FIG. 12A.

Referring to FIGS. 12A to 12C, a nano sheet dielectric layer 25 may be formed on exposed portions of the narrow sheets 13P. The nano sheet dielectric layer 25 may be referred to as a "gate dielectric layer".

The nano sheet dielectric layer 25 may be formed by oxidizing the surfaces of the narrow sheets 13P. In some embodiments, the nano sheet dielectric layer 25 may be formed by deposition and oxidation processes of silicon oxide. The nano sheet dielectric layer 25 may include silicon oxide, silicon nitride, metal oxide, metal oxide nitride, metal silicate, a high-k material, a ferroelectric material, an anti-ferroelectric material, or a combination thereof. The nano sheet dielectric layer 25 may include SiO₂, Si₃N₄, HfO₂, Al₂O₃, ZrO₂, AlON, HfON, HfSiO, HfSiON, or a combination thereof. The nano sheet dielectric layer 25 may be formed on all surfaces of the narrow sheets 13P.

The first spacer layer 26A may be formed on the nano sheet dielectric layer 25. The first spacer layer 26A may include, for example, silicon nitride. The first spacer layer 26A may surround and cover the narrow sheets 13P on the nano sheet dielectric layer 25. The first spacer layer 26A may be thicker than the nano sheet dielectric layer 25.

Second inter-cell dielectric layers 27A may be formed on the first spacer layer 26A. The second inter-cell dielectric layers 27A may each include, for example, silicon oxide.

The nano sheet dielectric layer 25 and the first spacer layer 26A may also be formed on the surface of the substrate 11.

As described above, the first spacer layer 26A may be disposed between the narrow sheets 13P in the third direction D3.

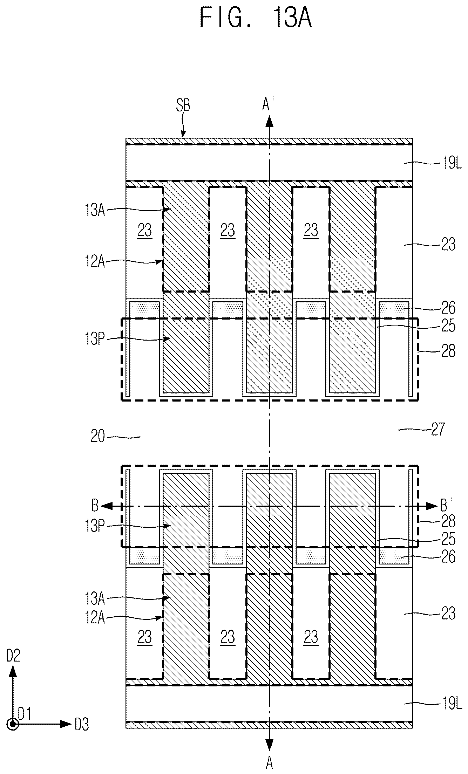

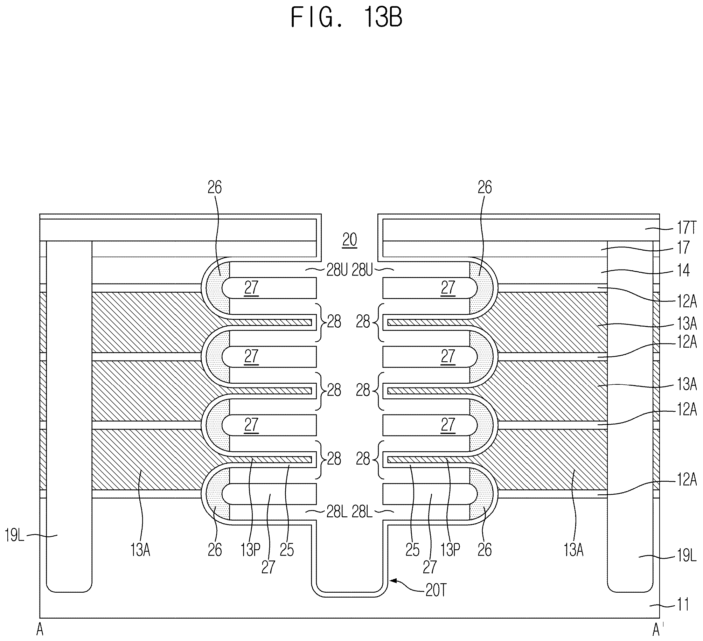

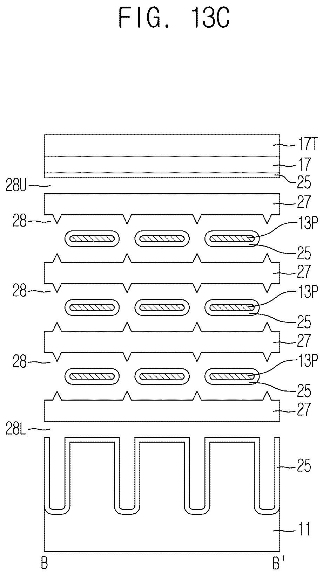

FIG. 13A is a plan view illustrating a structure at the narrow sheet level for illustrating a method for forming first spacers 26. FIG. 13B is a cross-sectional view of the structure taken along line A-A' illustrated in FIG. 13A. FIG. 13C is a cross-sectional view of the structure taken along line B-B' illustrated in FIG. 13A.

Referring to FIGS. 13A to 13C, the second inter-cell dielectric layers 27A may be cut through the first linear opening 20. Subsequently, the first spacer layer 26A may be selectively recessed. The remaining first spacer layers may become the first spacers 26, and the second inter-cell dielectric layers may remain as indicated by reference numeral "27".

As the first spacers 26 are formed, linear surrounding recesses 28 surrounding the narrow sheets 13P may be formed on the nano sheet dielectric layer 25. Each of the second inter-cell dielectric layers 27 may be disposed between the linear surrounding recesses 28 that are vertically disposed. An upper-level dummy horizontal recess 28U may be formed on an uppermost second inter-cell dielectric layer 27, and a lower-level dummy horizontal recess 28L may be formed below a lowermost second inter-cell dielectric layer 27. The upper-level and lower-level dummy horizontal recesses 28U and 28L may each have a non-surrounding shape, i.e., a flat shape.

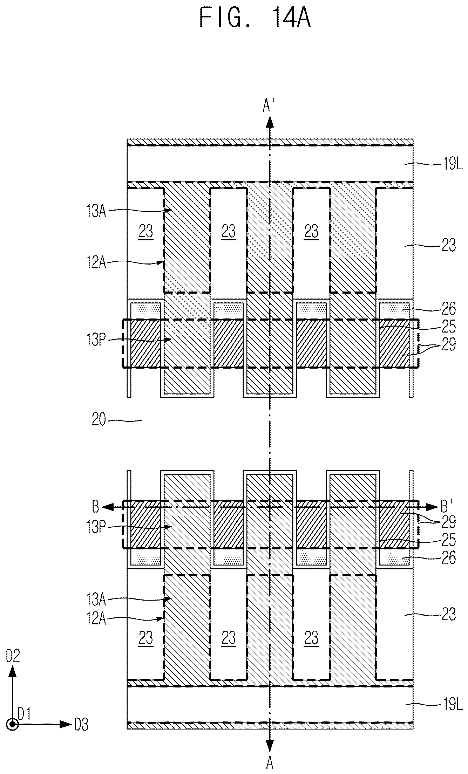

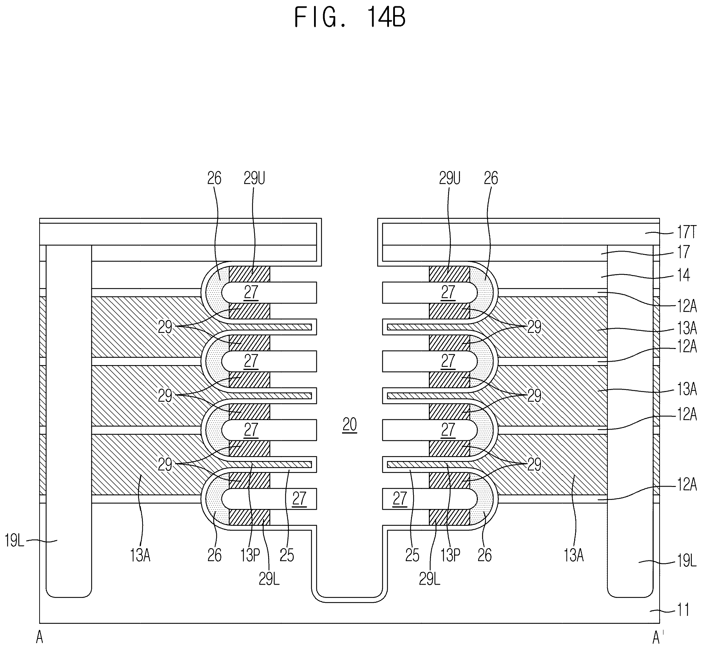

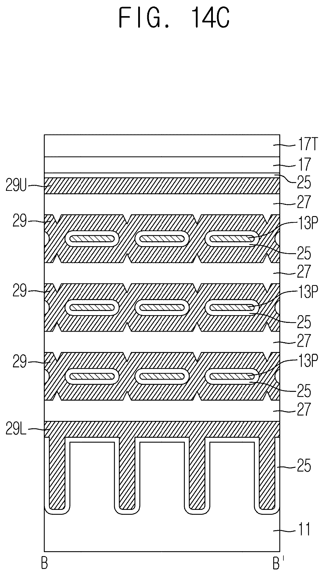

FIG. 14A is a plan view illustrating a structure at the narrow sheet level for illustrating a method for forming horizontal conductive lines 29. FIG. 14B is a cross-sectional view of the structure taken along line A-A' illustrated in FIG. 14A. FIG. 14C is a cross-sectional view of the structure taken along line B-B' illustrated in FIG. 14A.

Referring to FIGS. 14A to 14C, the horizontal conductive lines 29 may be formed to fill the linear surrounding recesses 28. The horizontal conductive lines 29 may horizontally extend in the third direction D3.

Forming the horizontal conductive lines 29 may include depositing a conductive material filling the linear surrounding recesses 28 on the nano sheet dielectric layer 25 and performing a horizontal etch-back process on the conductive material. Each of the horizontal conductive lines 29 may simultaneously surround the narrow sheets 13P at the same level. The horizontal conductive lines 29 may each include a metal-based material, a semiconductive material, or a combination thereof. The horizontal conductive lines 29 may each include molybdenum, molybdenum nitride, ruthenium, titanium nitride, tungsten, polysilicon, or a combination thereof. For example, the horizontal conductive lines 29 may each include a titanium nitride and tungsten (TiN/W) stack in which titanium nitride and tungsten are sequentially stacked. The horizontal conductive lines 29 may each include an N-type work function material or a P-type work function material. The N-type work function material may have a low work function of approximately 4.5 eV or less, and the P-type work function material may have a high work function of approximately 4.5 eV or greater. Each of the second inter-cell dielectric layers 27 may be disposed between a plurality of horizontal conductive lines 29 in the first direction D1. The horizontal conductive lines 29 surrounding the narrow sheets 13P may be referred to as "gate-all-around (GAA) electrodes". The narrow sheets 13P may be referred to as "nano sheet channels", "nano wires" or "nano wire channels".

A lower-level dummy horizontal electrode 29L may be formed on the surface of the substrate 11. An upper-level dummy horizontal electrode 29U may be formed over an uppermost horizontal conductive line 29. The dummy horizontal electrodes 29L and 29U may each have a non-surrounding shape.

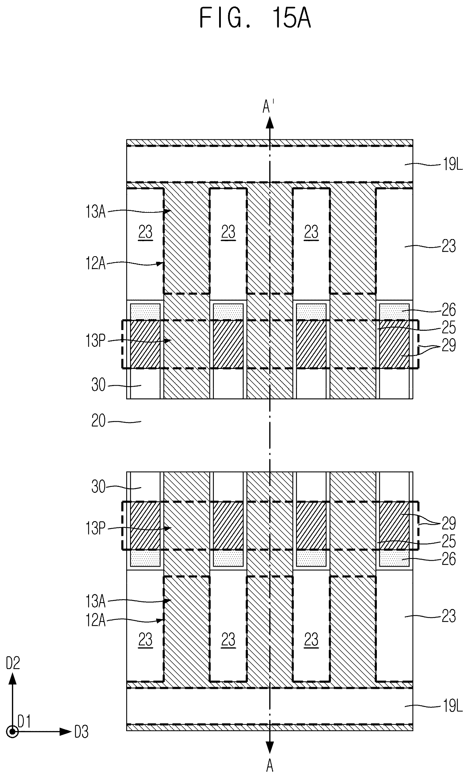

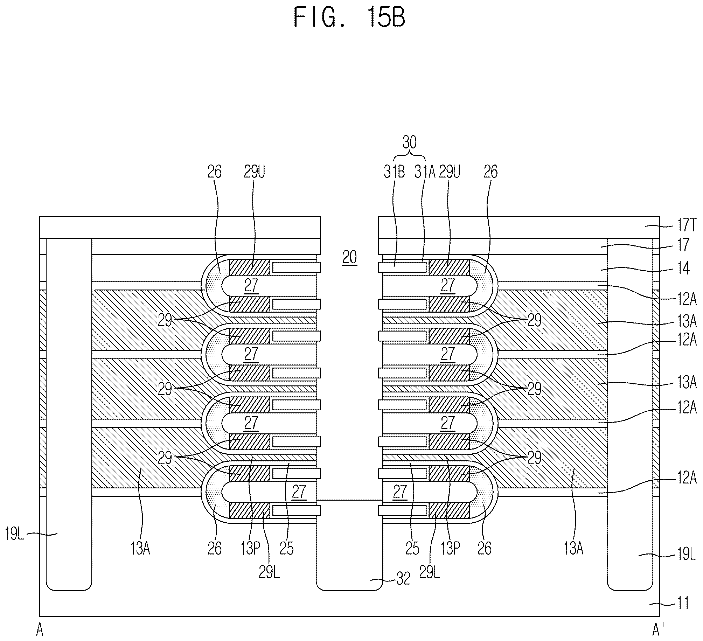

FIG. 15A is a plan view illustrating a structure at the narrow sheet level for illustrating a method for forming second spacers 30. FIG. 15B is a cross-sectional view of the structure taken along line A-A' illustrated in FIG. 15A.

Referring to FIGS. 15A and 15B, each of the second spacers 30 may be formed on one side of each of the horizontal conductive lines 29. The second spacer 30 may include silicon oxide, silicon nitride, silicon carbon oxide, an embedded air gap, or a combination thereof. Deposition and etch-back processes of a spacer material may be performed to form the second spacer 30. The second spacer 30 may include a stack of a silicon oxide liner 31A and a silicon nitride liner 31B. A portion of the silicon nitride liner 31B may protrude.

After the second spacers 30 are formed, a portion of the nano sheet dielectric layer 25 may be cut to expose one side of each of the narrow sheets 13P.

Subsequently, the deposition and etch-back processes may be performed on a first bottom passivation layer 32. An upper surface of the first bottom passivation layer 32 may be disposed at a level lower than a lowermost horizontal conductive line 29. The first bottom passivation layer 32 may include a dielectric material.

Each of the second spacers 30 may be disposed on one side of each of the horizontal conductive lines 29. The second spacer 30 may surround the narrow sheets 13P at the same horizontal level.

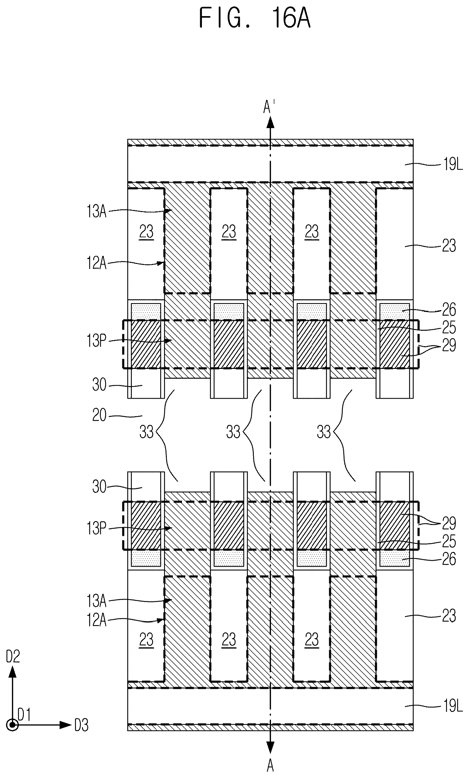

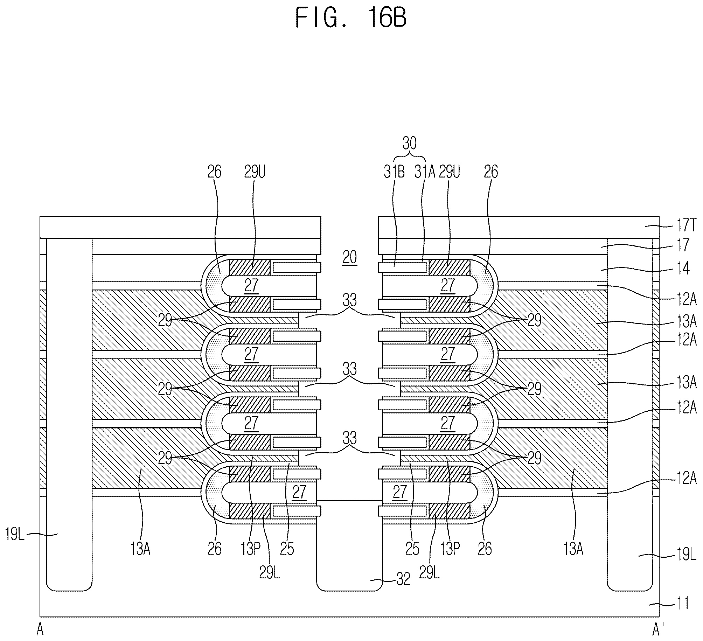

FIG. 16A is a plan view illustrating a structure at the narrow sheet level for illustrating a method for recessing the narrow sheets 13P. FIG. 16B is a cross-sectional view of the structure taken along line A-A' illustrated in FIG. 16A.

Referring to FIGS. 16A and 16B, the narrow sheets 13P may be horizontally recessed to form nano sheet level recesses 33.

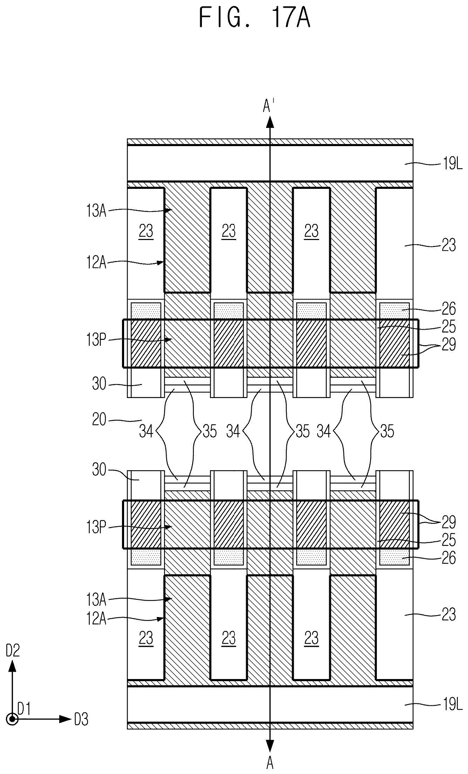

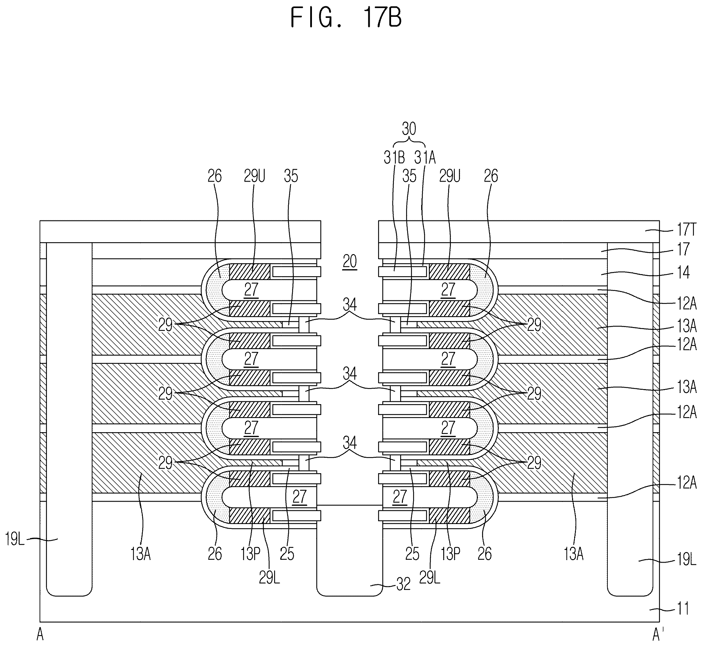

FIG. 17A is a plan view illustrating a structure at the narrow sheet level for illustrating a method for forming first contact nodes 34. FIG. 17B is a cross-sectional view of the structure taken along line A-A' illustrated in FIG. 17A.

Referring to FIGS. 17A and 17B, the first contact nodes 34 may be formed to fill the nano sheet level recesses 33. Forming the first contact nodes 34 may include depositing a conductive material filling the nano sheet level recesses 33 and performing an etch-back process on the conductive material. The first contact nodes 34 may each include a semiconductive material. The first contact nodes 34 may each include, for example, doped polysilicon, and the doped polysilicon may include N-type dopants. Each of the first contact nodes 34 may be disposed between the second spacers 30 that are vertically stacked. The first contact nodes 34 and the second spacers 30 may not be self-aligned in the first direction D1.

First doped regions 35 may be formed within sides of the narrow sheets 13P. A heat treatment process may be performed to form the first doped regions 35, and thus dopants may be diffused from the first contact nodes 34. In another method for forming the first doped regions 35, a selective epitaxial growth (SEG) or gas phase doping method may be applied.

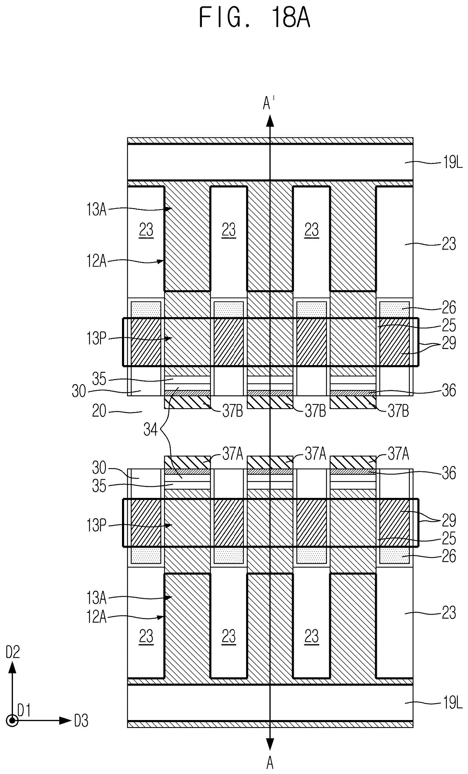

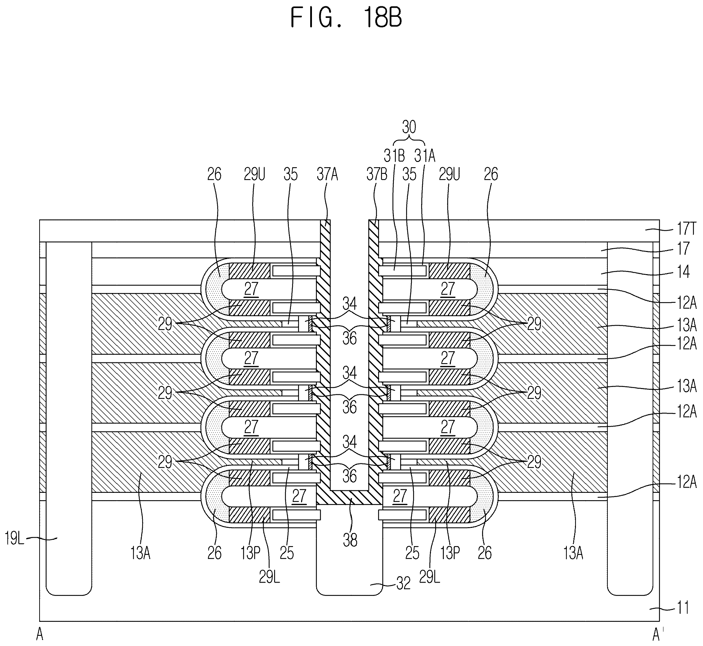

FIG. 18A is a plan view illustrating a structure at the narrow sheet level for illustrating a method for forming vertical conductive lines 37A and 37B. FIG. 18B is a cross-sectional view of the structure taken along line A-A' illustrated in FIG. 18A.

Referring to FIGS. 18A and 18B, ohmic contact layers 36 may be formed on the first contact nodes 34. The ohmic contact layers 36 may each include metal silicide.

The vertical conductive lines 37A and 37B may be formed on the ohmic contact layers 36. The vertical conductive lines 37A and 37B may be coupled in common to the ohmic contact layers 36. Accordingly, the vertical conductive lines 37A and 37B may be coupled in common to the narrow sheets 13P disposed in the first direction D1. The vertical conductive lines 37A and 37B may each include a metal-based material. The vertical conductive lines 37A and 37B may each include titanium nitride, tungsten, or a combination thereof.

The deposition and etch processes may be performed on a vertical conductive line material to form the vertical conductive lines 37A and 37B.

Bottom portions 38 of the vertical conductive lines 37A and 37B may be merged with each other. The vertical conductive lines 37A and 37B may be disposed in the first linear opening 20. The vertical conductive lines 37A and 37B may vertically extend in the first direction D1. The bottom portions 38 of the vertical conductive lines 37A and 37B may be merged with each other. The vertical conductive lines 37A and 37B may be coupled in common to the ohmic contact layers 36. Accordingly, the vertical conductive lines 37A and 37B may be coupled in common to the narrow sheets 13P disposed in the first direction D1.

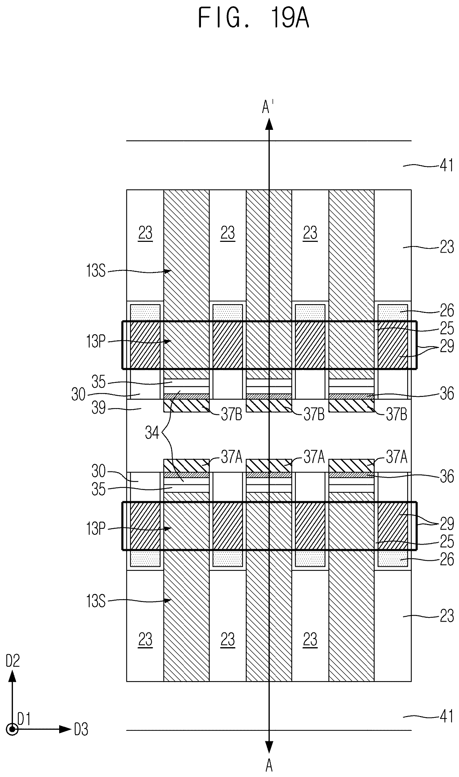

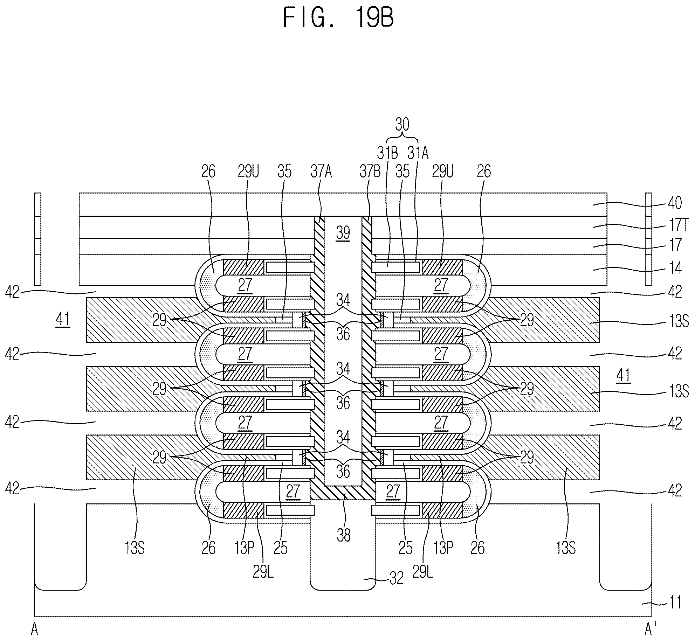

FIG. 19A is a plan view illustrating a structure at a nano sheet level for illustrating a method for forming second linear openings 41. FIG. 19B is a cross-sectional view of the structure taken along line A-A' illustrated in FIG. 19A.

Referring to FIGS. 19A and 19B, a vertical isolation layer 39 may be formed to fill the first linear opening 20 on the vertical conductive lines 37A and 37B. The vertical isolation layer 39 may vertically extend in the first direction D1 and horizontally extend in the third direction D3. The vertical conductive lines 37A and 37B disposed adjacent to each other in the third direction D3 may be isolated by the vertical isolation layer 39. The vertical isolation layer 39 may include a dielectric material. The vertical isolation layer 39 may include silicon oxide, silicon nitride, an air gap, or a combination thereof.

Subsequently, the second linear sacrificial layer 19L may be removed using a fourth hard mask layer 40 as a barrier. Accordingly, the second linear openings 41 may be formed.

After the second linear openings 41 are formed, the first mold layers 12A may be selectively recessed through the second linear openings 41. To selectively recess the first mold layers 12A, the difference in etch selectivity between the first mold layers 12A and the original body portions 13A may be used. The first mold layers 12A may be removed using a wet etch process or a dry etch process. For example, when the first mold layers 12A include silicon germanium layers and the original body portions 13A include monocrystalline silicon layers, the silicon germanium layers may be etched using an etchant or etching gas having a selectivity with respect to the monocrystalline silicon layers.

Subsequently, the original body portions 13A may be recessed. To recess the original body portions 13A, the wet etch process or the dry etch process may be used. Vertical thicknesses of the original body portions 13A may be reduced, as indicated by reference numeral "13S". Hereinafter, the original body portions having the reduced vertical thicknesses are referred to as "recessed body portions 13S".

Each of inter-body recesses 42 may be formed between the recessed body portions 13S that are vertically disposed.

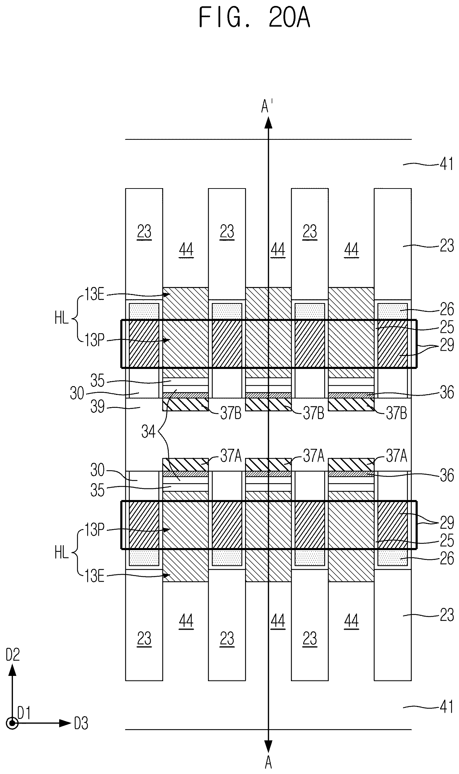

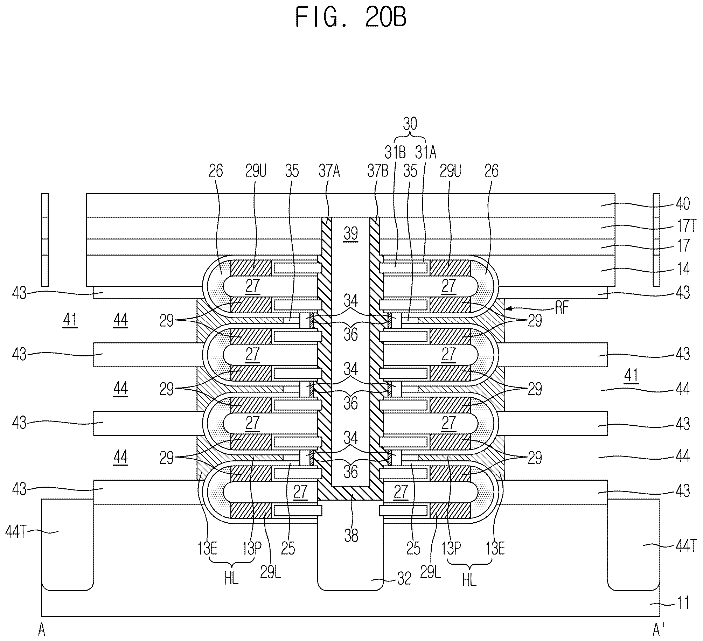

FIG. 20A is a plan view illustrating a structure at the narrow sheet level for illustrating a method for forming nano sheets HL. FIG. 20B is a cross-sectional view of the structure taken along line A-A' illustrated in FIG. 20A.

Referring to FIGS. 20A and 20B, third inter-cell dielectric layers 43 may be formed to fill the inter-body recesses 42. The third inter-cell dielectric layers 43 may each include, for example, silicon oxide.

After the third inter-cell dielectric layers 43 are formed, second bottom passivation layers 44T may be formed. The second bottom passivation layers 44T may each include a dielectric material.

After the second bottom passivation layers 44T are formed, storage openings 44 may be formed by horizontal recessing of the recessed body portions 13S. The storage openings 44 may be referred to as "capacitor openings". The nano sheets HL may be formed by the horizontal recessing of the recessed body portions 13S. Each of the nano sheets HL may include a narrow sheet 13P and a wide sheet 13E. The wide sheet 13E of the nano sheet HL refer to the recessed body portion 13S remaining after the recessing. An average vertical height of the wide sheet 13E of the nano sheet HL in the first direction D1 may be greater than an average vertical height of the narrow sheet 13P. A thickness of the wide sheet 13E of the nano sheet HL may gradually increase in the second direction D2. A horizontal length of the wide sheet 13E in the second direction D2 may be less than a horizontal length of the narrow sheet 13P. The wide sheet 13E of the nano sheet HL may have a fan-like shape. The wide sheet 13E may be referred to as a "fan-shaped sheet", and the narrow sheet 13P may be referred to as a "flat plate-shaped sheet".

To form the nano sheets HL each including the wide sheet 13E, the recessed body portions 13S may be isotropically or anisotropically etched. One side of the wide sheet 13E, i.e., the side exposed by each of the storage openings 44, may have a flat shape (refer to reference symbol "RF"). The one side of the wide sheet 13E may have various shapes, which are to be described later.

Each of the nano sheets HL may include a first edge and a second edge. The first edge refers to a portion electrically coupled to the vertical conductive lines 37A and 37B, the first contact node 34 and the ohmic contact layer 36. The second edge refers to a portion exposed by each of the storage openings 44.

Each of the storage openings 44 may be disposed between the third inter-cell dielectric layers 43.

In some embodiments, the horizontal recessing of the recessed body portions 13S for forming the wide sheets 13E may stop at a boundary area between the narrow sheet 13P and the wide sheet 13E.

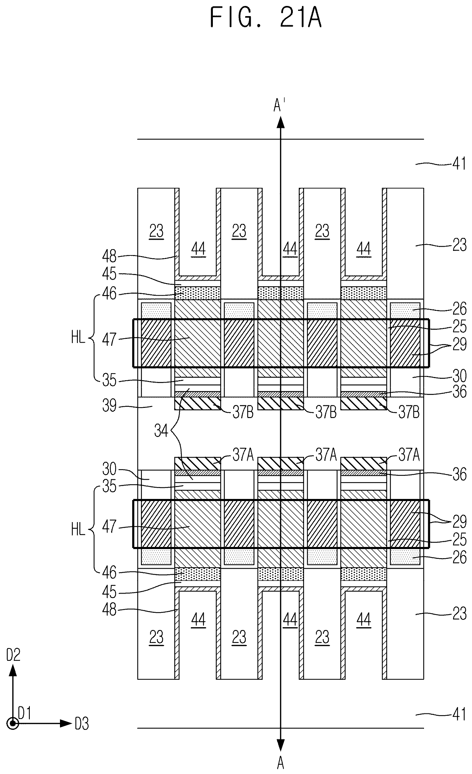

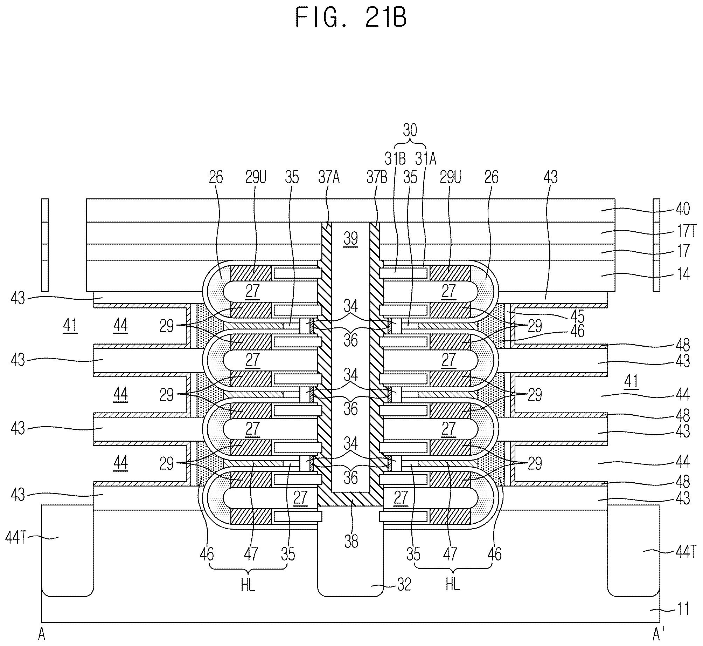

FIG. 21A is a plan view illustrating a structure at the nano sheet level for illustrating a method for forming second contact nodes 45 and first electrodes 48. FIG. 21B is a cross-sectional view illustrating a structure taken along line A-A' illustrated in FIG. 21A.

Referring to FIGS. 21A and 21B, a pre-cleaning process may be performed on one side of the nano sheets HL, that is, the surfaces of the wide sheets 13E.

Subsequently, the second contact nodes 45 may be formed on one side of the nano sheets HL, that is, the wide sheets 13E. Forming the second contact nodes 45 may include selective epitaxial growth (SEG). For example, a semiconductor material may be grown from the side surfaces of the wide sheets 13E through the selective epitaxial growth (SEG). The second contact nodes 45 may each include SEG Si. Since the wide sheets 13E each include monocrystalline silicon, a silicon layer may be epitaxially grown along crystal surfaces of the side surfaces of the wide sheets 13E.

The second contact nodes 45 may each include a dopant. When the silicon layer is grown using the selective epitaxial growth (SEG), dopants may be doped in situ. Accordingly, the second contact nodes 45 may each be a doped epitaxial layer. The second contact nodes 45 may each include an N-type dopant as the dopant. The N-type dopant may include phosphorus, arsenic, antimony, or a combination thereof. The second contact nodes 45 may each include a phosphorus-doped silicon epitaxial layer formed by the selective epitaxial growth (SEG), i.e., a doped SEG SiP. In some embodiments, the first contact nodes 34 may also be formed by the selective epitaxial growth (SEG).

Since the second contact nodes 45 are formed using the selective epitaxial growth (SEG), void-free or seam-free second contact nodes 45 may be formed. Since the second contact nodes 45 are formed using the selective epitaxial growth (SEG), a process for forming the second contact nodes 45 may be simplified.

Each of the second contact nodes 45 may be disposed between the third inter-cell dielectric layers 43 that are vertically stacked.

Second doped regions 46 may be formed in the wide sheets 13E of the nano sheets HL. A heat treatment process may be performed to form the second doped regions 46, and thus, dopants may be diffused from the second contact nodes 45.

Each of the nano sheets HL may include the first doped region 34, the second doped region 46, and a channel 47. The channel 47 may be defined between the first doped region 34 and the second doped region 46. The first doped region 34 and the channel 47 may be formed in the narrow sheet 13P. The second doped region 46 may be formed in the wide sheet 13E. A portion of each of the second doped regions 46 may extend into the narrow sheets 13P. One side of each of the second doped regions 46 of the nano sheets HL may be coupled to the channel 47. The other side of each of the second doped regions 46 of the nano sheets HL may be coupled to the second contact nodes 45.

In some embodiments, an ohmic contact layer including metal silicide may be further formed after the second contact nodes 45 are formed.

Subsequently, the first electrodes 48 of a data storage element may be formed on the second contact nodes 45. The first electrodes 48 may each have a horizontally-oriented cylindrical shape. Each of the first electrodes 48 may be disposed in a different one of the storage openings 44. The first electrodes 48 disposed adjacent to each other in the second direction D2 may be spaced apart from each other by the second linear openings 41. The first electrodes 48 disposed adjacent to each other in the third direction D3 may be spaced apart from each other by the first inter-cell dielectric layers 23. The first electrodes 48 disposed adjacent to each other in the first direction D1 may be spaced apart from each other by the third inter-cell dielectric layers 43. Forming the first electrodes 48 may include depositing a metal material, gap-filling a sacrificial material, and isolating the metal material in a vertical/horizontal direction. The sacrificial material may include oxide or polysilicon.

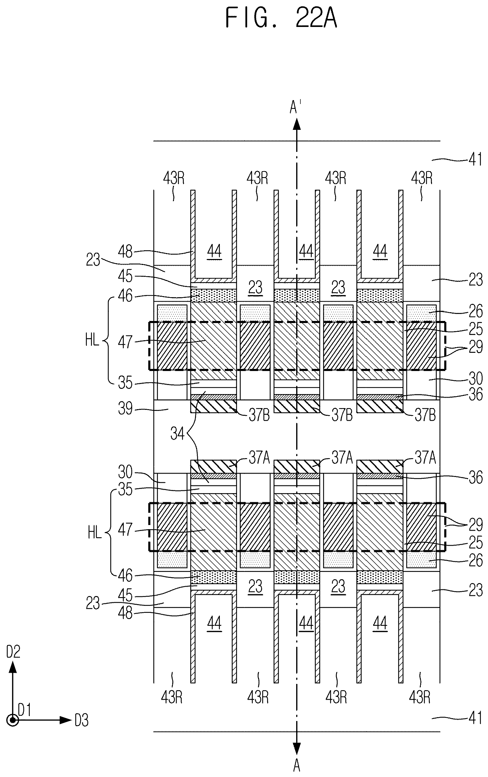

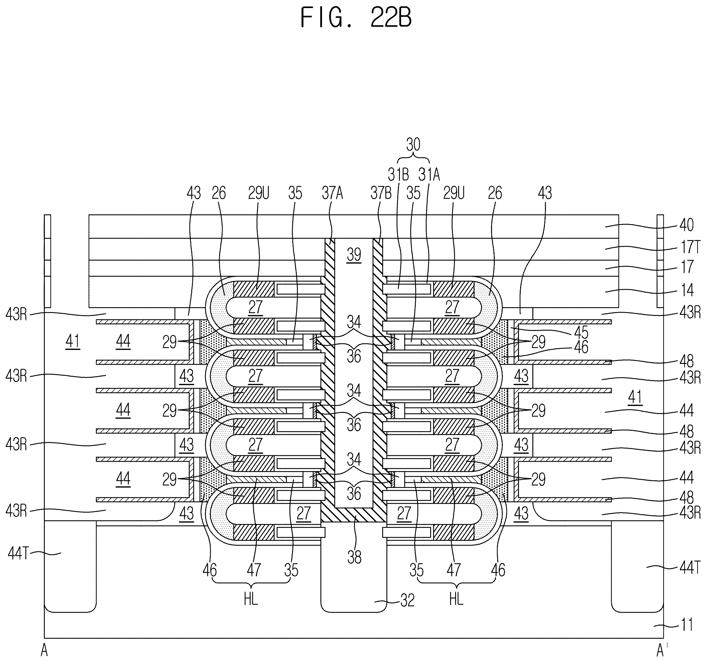

FIG. 22A is a plan view illustrating a structure at the nano sheet level for illustrating a method for recessing first and third inter-cell dielectric layers 23 and 43. FIG. 22B is a cross-sectional view illustrating a structure taken along line A-A' illustrated in FIG. 22A.

Referring to FIGS. 22A and 22B, portions of the first and third inter-cell dielectric layers 23 and 43 may be horizontally recessed (refer to reference numeral "43R"). Accordingly, the outer walls of the first electrodes 48 may be partially exposed. The first electrodes 48 may each have a semi-cylindrical shape. Horizontal recess depths of the first and third inter-cell dielectric layers 23 and 43 may be a depth that does not expose the second contact nodes 45.

Each of the first electrodes 48 may include an inner space and a plurality of outer surfaces. The inner space of the first electrode 48 may include a plurality of inner surfaces. The outer surfaces of the first electrode 48 may include a vertical outer surface and a plurality of horizontal outer surfaces. The vertical outer surface of the first electrode 48 may vertically extend in the first direction D1. The horizontal outer surfaces of the first electrode 48 may horizontally extend in the second direction D2 or the third direction D3. The inner space of the first electrode 48 may be a three-dimensional space.

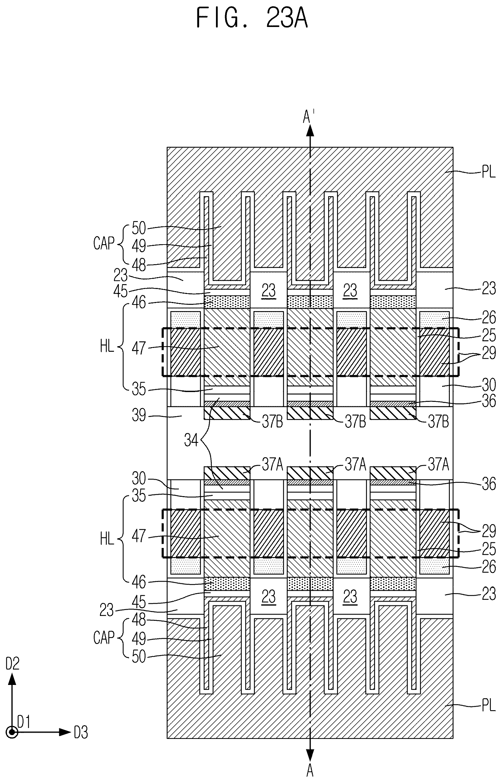

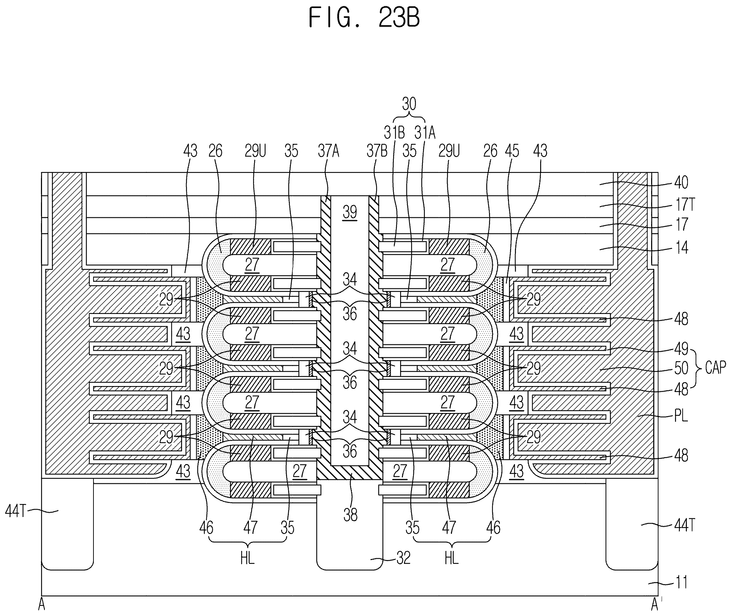

FIG. 23A is a plan view illustrating a structure at the nano sheet level for illustrating a method for forming a second electrode 50 of the data storage element. FIG. 23B is a cross-sectional view of the structure taken along line A-A' illustrated in FIG. 23A.

Referring to FIGS. 23A and 23B, a dielectric layer 49 and the second electrode 50 may be sequentially formed on the first electrodes 48. The first electrode 48, the dielectric layer 49 and the second electrode 50 may be the data storage element CAP.

The dielectric layer 49 may conformally cover the inner surfaces and horizontal outer surfaces of the first electrode 48. The second electrode 50 may be disposed on the inner space and horizontal outer surfaces of the first electrode 48 on the dielectric layer 49. Among the outer surfaces of the first electrode 48, the vertical outer surface may be electrically coupled to the nano sheet HL and the second contact node 45.

The first electrode 48 may have a semi-cylindrical shape. The semi-cylindrical shape of the first electrode 48 may include cylindrical inner surfaces and semi-cylindrical outer surfaces. The dielectric layer 49 and the second electrode 50 may be disposed on the cylindrical inner surfaces of the first electrode 48. A portion of the dielectric layer 49 and a portion of the second electrode 50 may extend to be disposed on the semi-cylindrical outer surfaces of the first electrode 48. The second electrode 50 may vertically extend in the first direction D1.

The first electrode 48 and the second electrode 50 may each include metal, noble metal, metal nitride, conductive metal oxide, conductive noble metal oxide, metal carbide, metal silicide, or a combination thereof. For example, the first electrode 48 and the second electrode 50 may each include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof. The second electrode 50 may also include a combination of a metal-based material and a silicon-based material. For example, the second electrode 50 may be a titanium nitride/silicon germanium/tungsten nitride (TiN/SiGe/WN) stack. In the titanium nitride/silicon germanium/tungsten nitride (TiN/SiGe/WN) stack, silicon germanium may be a gap-fill material filling the inner space of the first electrode 48, titanium nitride (TiN) may serve as the second electrode 50 of the data storage element CAP, and tungsten nitride may be a low-resistivity material.

The dielectric layer 49 may be referred to as a "capacitor dielectric layer" or a "memory layer". The dielectric layer 49 may include silicon oxide, silicon nitride, a high-k material, a ferroelectric material, an antiferroelectric material, a perovskite material, or a combination thereof. The dielectric layer 49 may include a high-k material such as hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). The dielectric layer 49 may include a ZA (ZrO₂/Al₂O₃) stack, a ZAZ (ZrO₂/Al₂O₃/ZrO₂) stack, a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HAHA (HfO₂/Al₂O₃/HfO₂/Al₂O₃) stack, a HAHAH (HfO₂/Al₂O₃/HfO₂/Al₂O₃/HfO₂) stack, a HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, a HZHZ (HfO₂/ZrO₂/HfO₂/ZrO₂) stack, or an AHZAZHA (Al₂O₃/HfO₂/ZrO₂/Al₂O₃/ZrO₂/HfO₂/Al₂O₃) stack.

In some embodiments, an interface control layer may be further formed between the first electrode 48 and the dielectric layer 49 to alleviate leakage current. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode 50 and the dielectric layer 49.

As described above, a method for fabricating the semiconductor device may include forming the nano sheet target layers 13 that are vertically stacked spaced apart from each other over the substrate 11, forming the flat plate-shaped narrow sheets 13P that trim first portions of the nano sheet target layers 13, horizontally recessing second portions of the nano sheet target layers 13 to form the fan-shaped wide sheets 13E, selectively growing the second contact nodes 45 on side surfaces of the wide sheets 13E, and forming the data storage element CAP coupled to each of the second contact nodes 45.

From another perspective, a method for fabricating the semiconductor device may include forming the nano sheet target layers 13 that are vertically stacked spaced apart from each other over the substrate 11, forming the flat plate-shaped narrow sheets 13P that trim first portions of the nano sheet target layers 13, forming the horizontal conductive lines 29 extending while surrounding the narrow sheets 13P disposed at the same horizontal level, forming the first contact nodes 34 coupled to the narrow sheets 13P, forming the vertical conductive lines 37A and 37B coupled to the first contact nodes 34, horizontally recessing second portions of the nano sheet target layers 13P to form the fan-shaped wide sheets 13E, selectively growing the second contact nodes 45 on the side surfaces of the wide sheets 13E, and forming the data storage element CAP coupled to each of the second contact nodes 45.

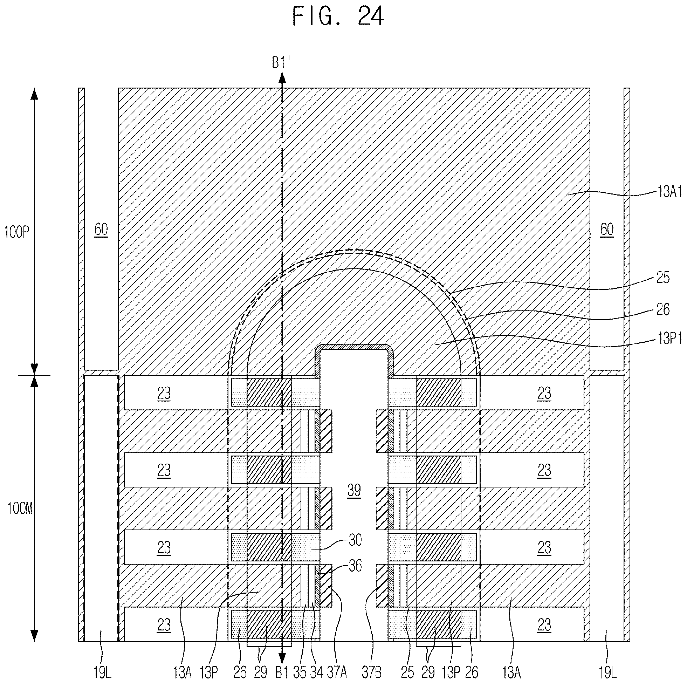

FIGS. 24 to 43 illustrate various views of a semiconductor device for illustrating a method for fabricating a coupling region 100P, in accordance with an embodiment of the present disclosure.

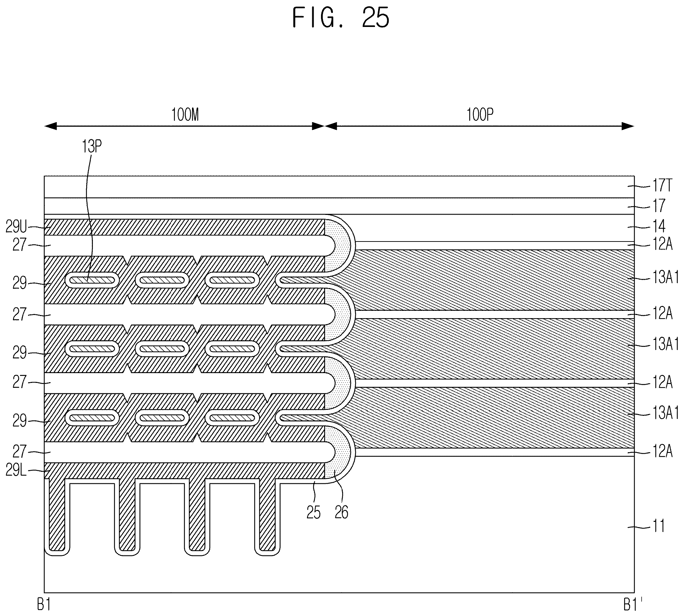

FIG. 24 is a plan view illustrating the semiconductor device to describe the method for fabricating the coupling region 100P. FIGS. 25 to 43 are cross-sectional views of the semiconductor device taken along line B1-B1' illustrated in FIG. 24 to describe the method for fabricating the coupling region 100P. A process for forming the coupling region 100P may be performed after the horizontal conductive lines 29 and the vertical conductive lines 37A and 37B are formed as described above with reference to FIGS. 18A and 18B.

As illustrated in FIGS. 24 and 25, horizontal conductive lines 29 surrounding narrow sheets 13P may be formed in a cell array region 100M. A vertical stack including first mold layers 12A and sacrificial sheets 13A1 may be disposed in the coupling region 100P. The sacrificial sheets 13A1 refer to second mold layers remaining in the coupling region 100P.

Subsequently, a portion of the vertical stack may be etched, and inter-pad isolation trenches 60 may be formed.

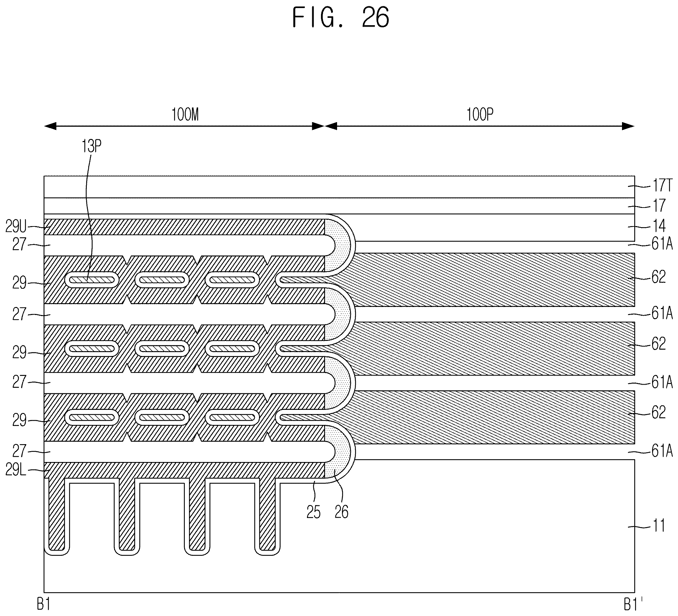

As illustrated in FIG. 26, the first mold layers 12A are first removed, and then a partial recess process is performed on the sacrificial sheets 13A1 to form sacrificial pad sheets 62 and inter-pad sheet recesses 61A between the sacrificial pad sheets 62. Accordingly, each of inter-pad sheet recesses 61A may be formed between the sacrificial pad sheets 62.

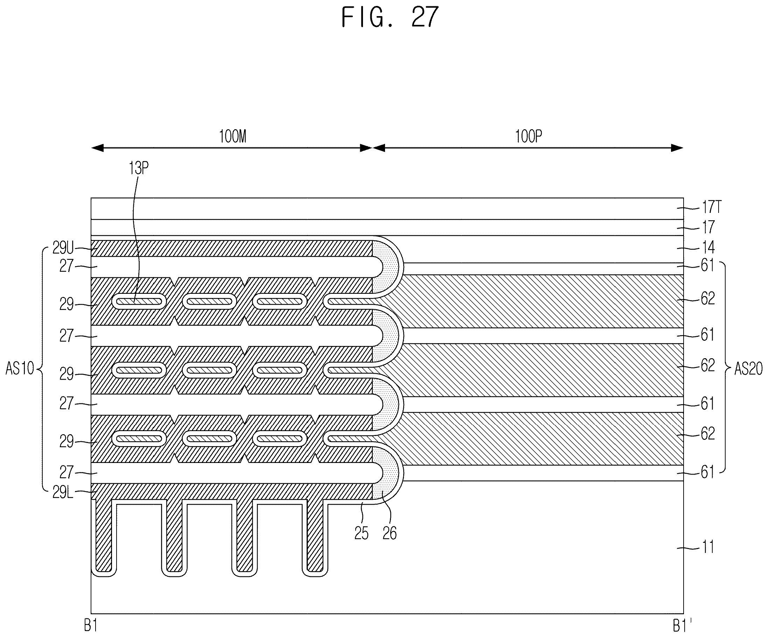

As illustrated in FIG. 27, inter-pad dielectric layers 61 may be formed to fill the inter-pad sheet recesses 61A. The inter-pad dielectric layers 61 may each include, for example, silicon oxide.

In the cell array region 100M, a first alternating stack AS10 including the horizontal conductive lines 29 may be formed, and in the coupling region 100P, a second alternating stack AS20 including the sacrificial pad sheets 62 and the inter-pad dielectric layers 61 may be formed to be horizontally spaced apart from the first alternating stack AS10.

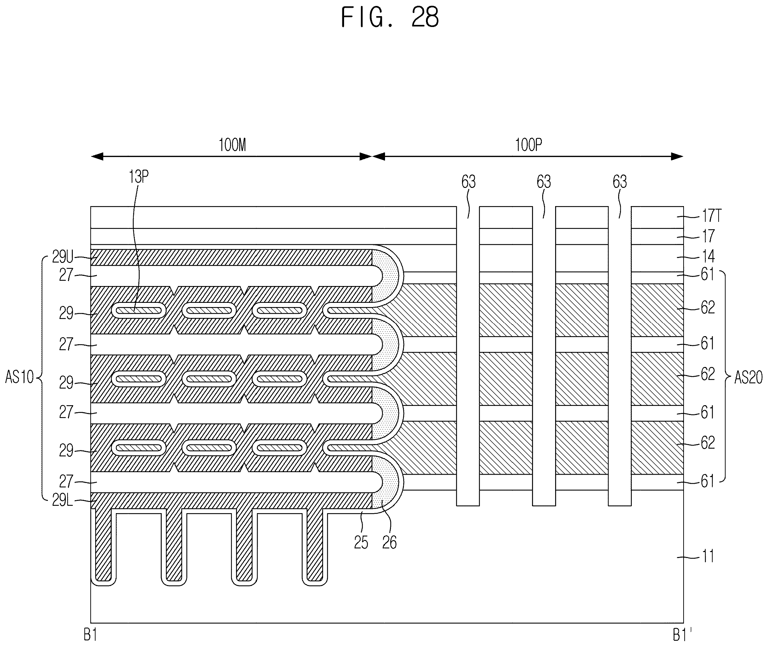

As illustrated in FIG. 28, a plurality of preliminary contact holes 63 may be formed to pass through the stack of inter-pad dielectric layers 61 and sacrificial pad sheets 62. The preliminary contact holes 63 may have the same depth as each other and may be spaced apart from each other at a regular interval.

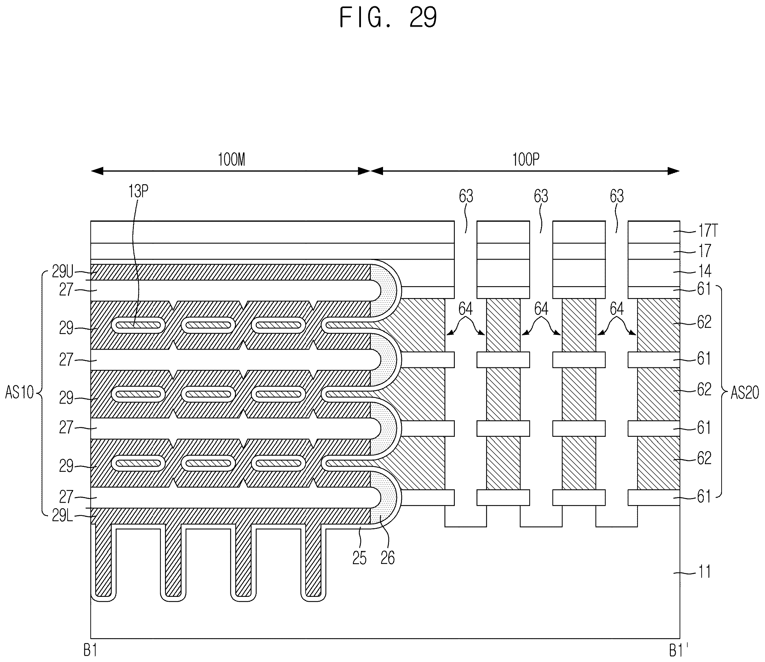

As illustrated in FIG. 29, the sacrificial pad sheets 62 may be partially and horizontally recessed through the preliminary contact holes 63. Accordingly, undercuts 64 may be formed between the inter-pad dielectric layers 61.

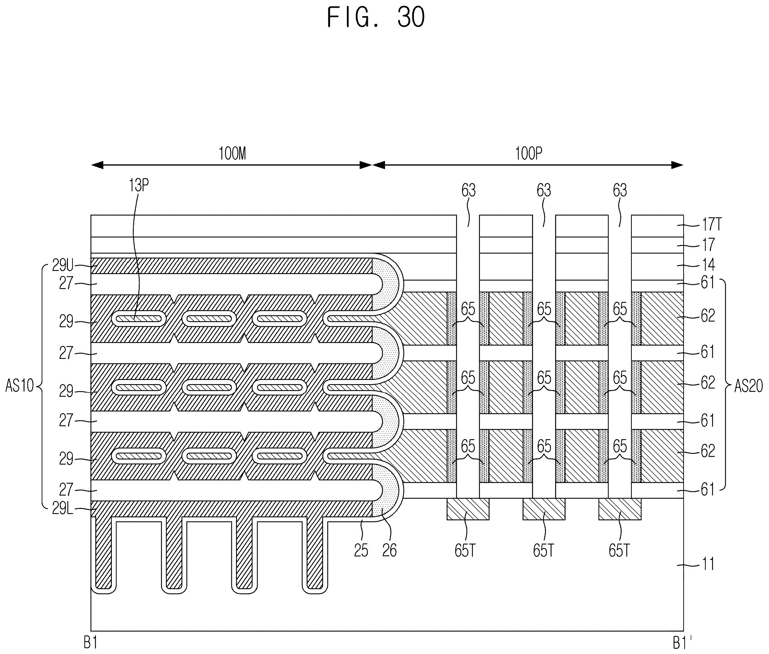

As illustrated in FIG. 30, contact spacers 65 may be formed to fill the undercuts 64. The contact spacers 65 may each include a dielectric material such as silicon nitride. Contact stop layers 65T may be formed in a substrate 11 while the contact spacers 65 are formed. The contact stop layers 65T and the contact spacers 65 may be of the same material.

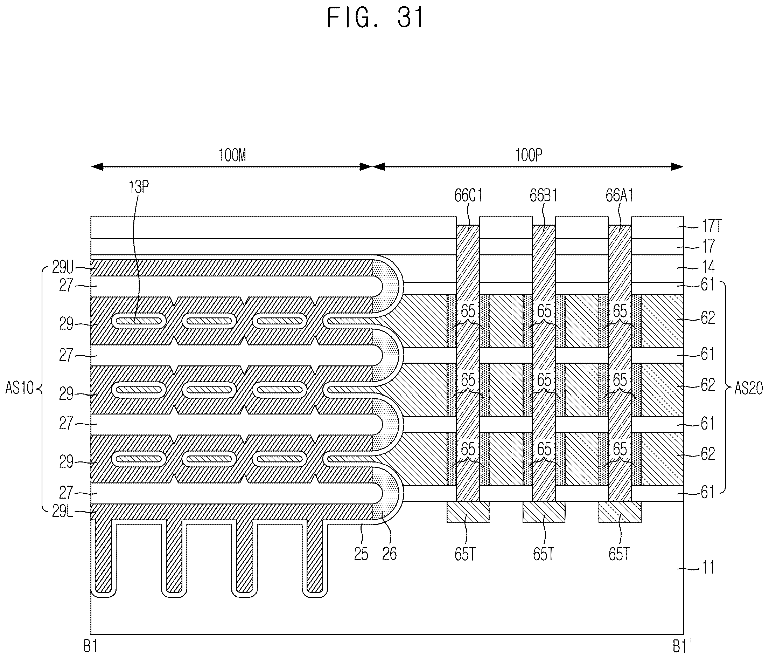

As illustrated in FIG. 31, each of first, second and third sacrificial plugs 66A1, 66B1 and 66C1 may be formed to fill a different one of the preliminary contact holes 63. The first, second and third sacrificial plugs 66A1, 66B1 and 66C1 may each include undoped polysilicon.

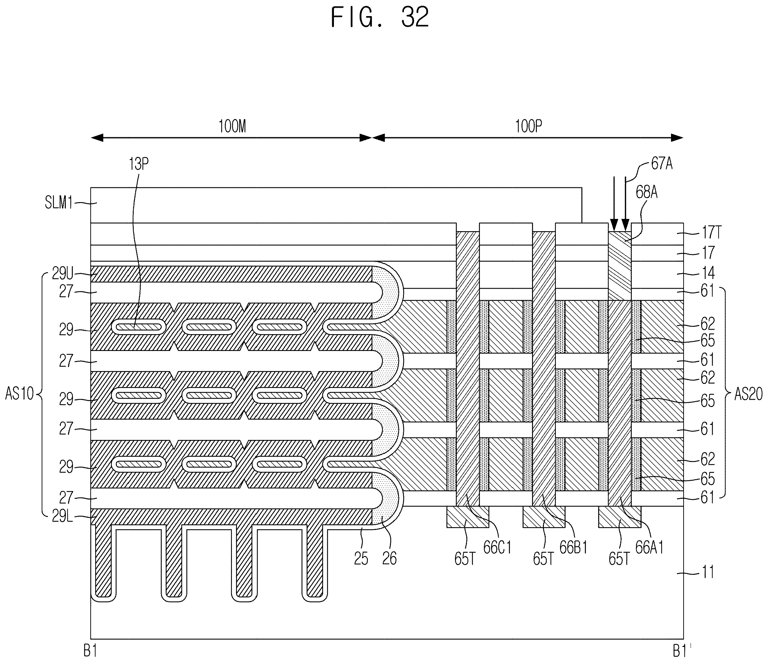

As illustrated in FIG. 32, after a first slim mask layer SLM1 is formed, the first sacrificial plug 66A1 may be exposed. The first slim mask layer SLM1 may include photoresist. The first slim mask layer SLM1 may cover each of the second and third sacrificial plugs 66B1 and 66C1.

Subsequently, first impurity doping 67A may be performed to form a first sacrificial doping portion 68A on an upper portion of the exposed first sacrificial plug 66A1. The first impurity doping 67A may use an implant method. The first impurity doping 67A may include an N-type impurity or a P-type impurity. The first sacrificial doping portion 68A may be doped polysilicon, and the first sacrificial plug 66A1 may be undoped polysilicon. Because there is a difference in etch rate between the undoped polysilicon and the doped polysilicon, the doped polysilicon may be selectively removed in subsequent processes. A depth of the first sacrificial doping portion 68A may be approximately 800 Å.

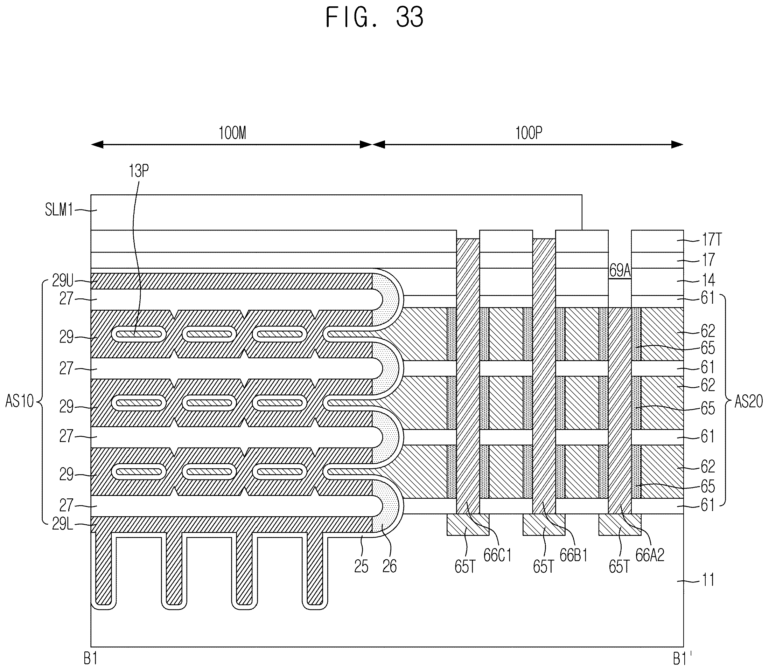

As illustrated in FIG. 33, the first sacrificial doping portion (reference numeral "68A" of FIG. 32) may be selectively removed to form a first sacrificial recess 69A over the first sacrificial plug 66A2. The first sacrificial plug from which the first sacrificial doping portion 68A is removed may remain as indicated by reference numeral "66A2". In some embodiments, when a plurality of first sacrificial recesses are simultaneously formed, impurity doping and a method for removing a sacrificial doping portion may be used so that depths of the first sacrificial recesses may be uniformly formed.

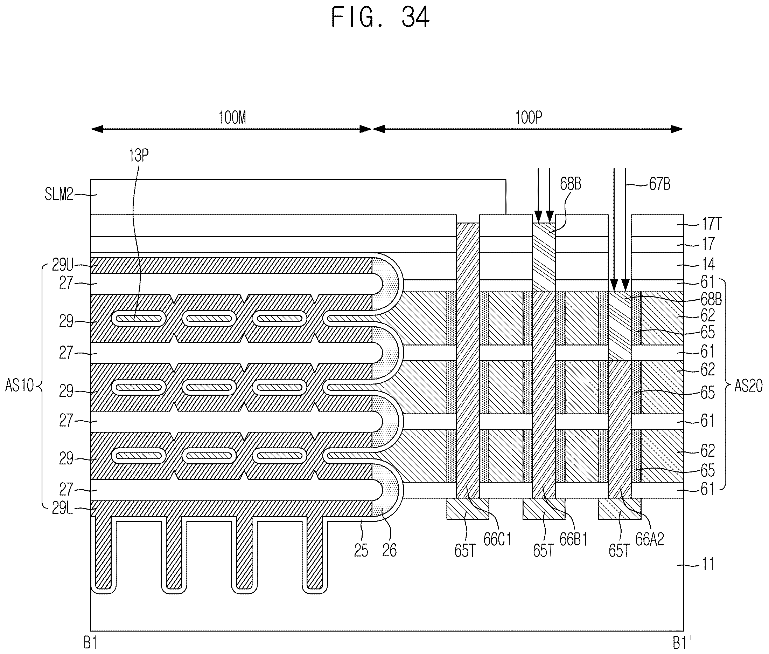

As illustrated in FIG. 34, a second slim mask layer SLM2 may be formed by trimming the first slim mask layer SLM1. The second slim mask layer SLM2 may expose the first sacrificial plug 66A2 and the second sacrificial plug 66B1. The second slim mask layer SLM2 may include photoresist. The second slim mask layer SLM2 may cover the third sacrificial plug 66C1.

Subsequently, second impurity doping 67B may be performed to form second sacrificial doping portions 68B on upper portions of the exposed first sacrificial plug 66A2 and the second sacrificial plug 66B1. The second impurity doping 67B may include an N-type impurity or a P-type impurity. Each of the second sacrificial doping portions 68B may be doped polysilicon. A depth of the second sacrificial doping portion 68B may be approximately 800 Å.

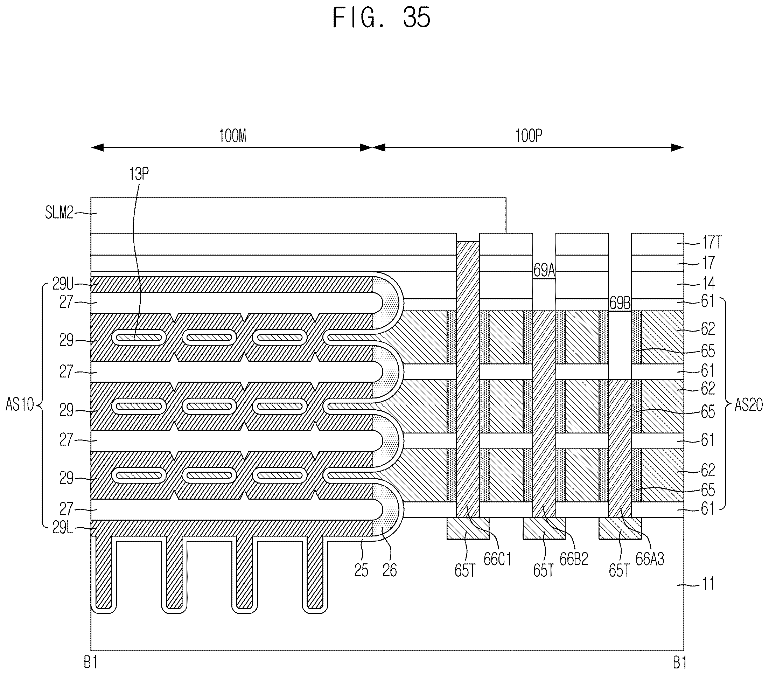

As illustrated in FIG. 35, the second sacrificial doped portions 68B may be selectively removed to form the first sacrificial recess 69A on an upper portion of the second sacrificial plug 66B2 and a second sacrificial recess 69B on an upper portion of the first sacrificial plug 66A3. The second sacrificial recess 69B may be deeper than the first sacrificial recess 69A. The first sacrificial plug from which the second sacrificial doped portion 68B is removed may remain as indicated by reference numeral "66A3", and the second sacrificial plug from which the second sacrificial doped portion 68B is removed may remain as indicated by reference numeral "66B2".

In some embodiments, when a plurality of second sacrificial recesses are simultaneously formed, impurity doping and a method for removing a sacrificial doping portion may be used so that depths of the second sacrificial recesses may be uniformly formed.

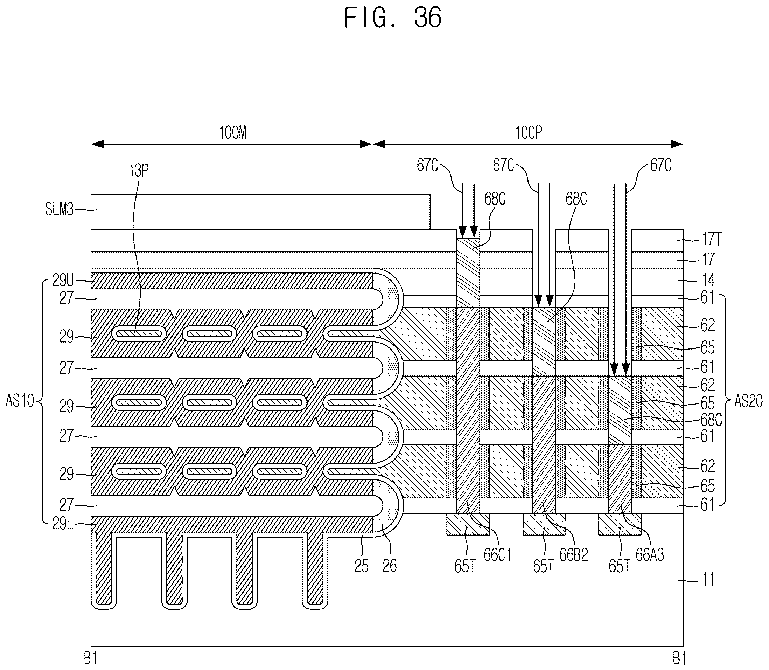

As illustrated in FIG. 36, a third slim mask layer SLM3 may be formed by trimming the second slim mask layer SLM2. The third slim mask layer SLM3 may expose the first sacrificial plug 66A3, the second sacrificial plug 66B2 and the third sacrificial plug 66C1. The third slim mask layer SLM3 may include photoresist.

Subsequently, third impurity doping 67C may be performed to form third sacrificial doping portions 68C on upper portions of the exposed first sacrificial plug 66A3, the second sacrificial plug 66B2 and the third sacrificial plug 66C1. The third impurity doping 67C may include an N-type impurity or a P-type impurity. Each of the third sacrificial doping portions 68C may be doped polysilicon. A depth of the third sacrificial doping portion 68C may be approximately 800 Å.

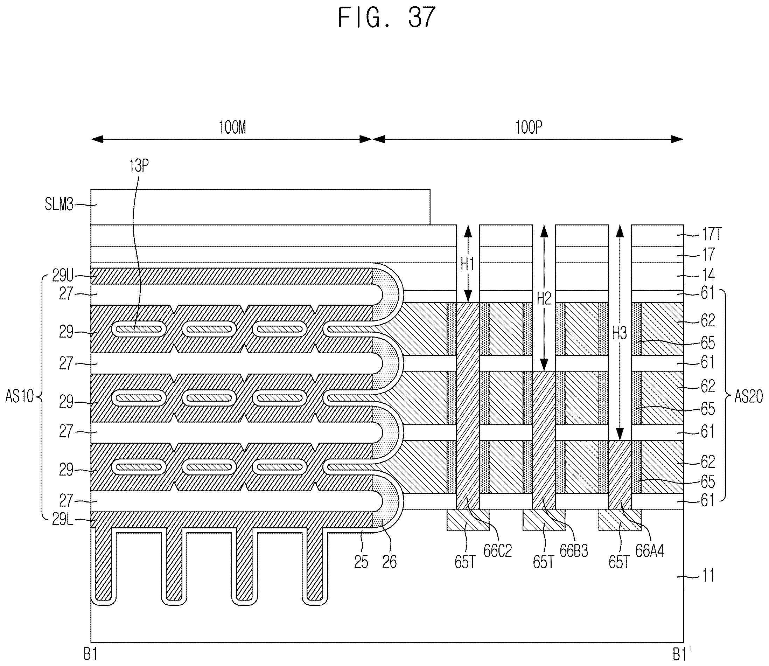

As illustrated in FIG. 37, the third sacrificial doping portions 68C may be selectively removed. Accordingly, a first sacrificial recess H1 may be formed over the third sacrificial plug 66C2, a second sacrificial recess H2 may be formed over the second sacrificial plug 66B3, and a third sacrificial recess H3 may be formed over the first sacrificial plug 66A4. The first sacrificial plug from which the third sacrificial doping portion 68C is removed may become a first sacrificial plug pattern 66A4 as indicated by reference numeral "66A4", the second sacrificial plug from which the third sacrificial doping portion 68C is removed may become a second sacrificial plug pattern 66B3 as indicated by reference numeral "66B3", and the third sacrificial plug from which the third sacrificial doping portion 68C is removed may become a third sacrificial plug pattern 66C2 as indicated by reference numeral "66C2". In some embodiments, when a plurality of third sacrificial recesses are simultaneously formed, impurity doping and a method for removing a sacrificial doping portion may be used so that depths of the third sacrificial recesses may be uniformly formed.

The second sacrificial recess H2 may be deeper than the first sacrificial recess H1, and the third sacrificial recess H3 may be deeper than the second sacrificial recess H2.

While forming the first to third slim mask layers SLM1, SLM2 and SLM3, performing the first to third impurity doping 67A, 67B and 67C, and forming the first to third sacrificial recesses H1, H2 and H3, which are described above, are repeated multiple times, the first to third sacrificial plug patterns 66A4, 66B3 and 66C2 having different heights may be formed. The height of the second sacrificial plug pattern 66B3 may be greater than the height of the first sacrificial plug pattern 66A4, and the height of the third sacrificial plug pattern 66C2 may be greater than the height of the second sacrificial plug pattern 66B3. The heights may gradually decrease in the order of the third sacrificial plug pattern 66C2, the second sacrificial plug pattern 66B3 and the first sacrificial plug pattern 66A4. A level between the horizontal conductive lines that are vertically stacked may be distinguished by the first to third sacrificial plug patterns 66A4, 66B3 and 66C2 having different heights.

Referring to FIGS. 25 to 37, post-treatment processes for the sacrificial plugs 66A1, 66B1 and 66C1 may be performed to form the sacrificial plug patterns 66A4, 66B3 and 66C2 having different heights and the sacrificial recesses H1, H2 and H3 having different depths. The post-treatment processes may include forming the slim mask layers SLM1, SLM2 and SLM3, performing impurity doping 67A, 67B and 67C to form sacrificial doping portions 68A, 68B, and 68C, and removing the sacrificial doping portions 68A, 68B and 68C. Because the sacrificial plugs are doped by trimming the slim mask layers, the sacrificial plugs may be uniformly recessed.

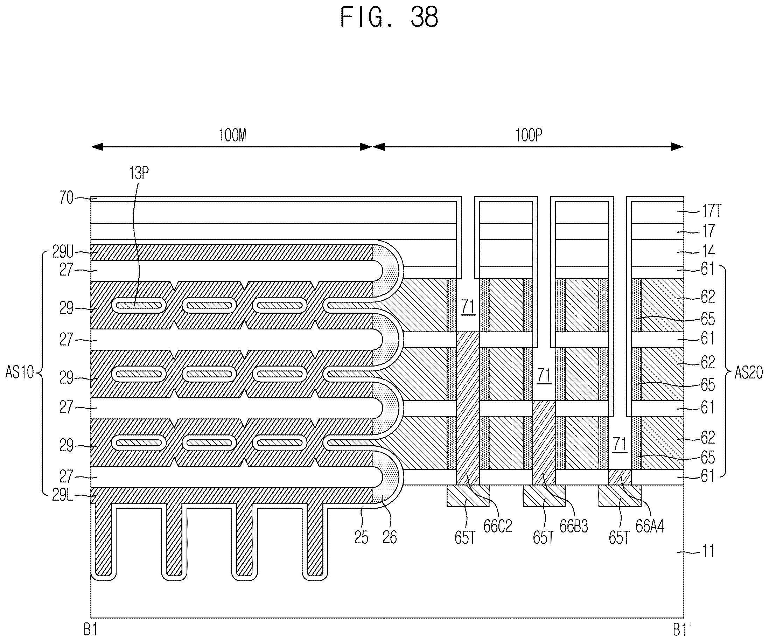

As illustrated in FIG. 38, a contact liner layer 70 may be formed on sidewalls of the sacrificial recesses H1, H2, and H3. The contact liner layer 70 may include a stack of oxide and nitride. After a bottom portion of the contact liner layer 70 is cut, the first to third sacrificial plug patterns 66A4, 66B3 and 66C2 may be vertically recessed 71. Accordingly, the contact spacers 65 may be exposed at respective levels. The heights of the first to third sacrificial plug patterns 66A4, 66B3 and 66C2 may decrease as indicated by reference numerals "66A", "66B" and "66C", respectively.

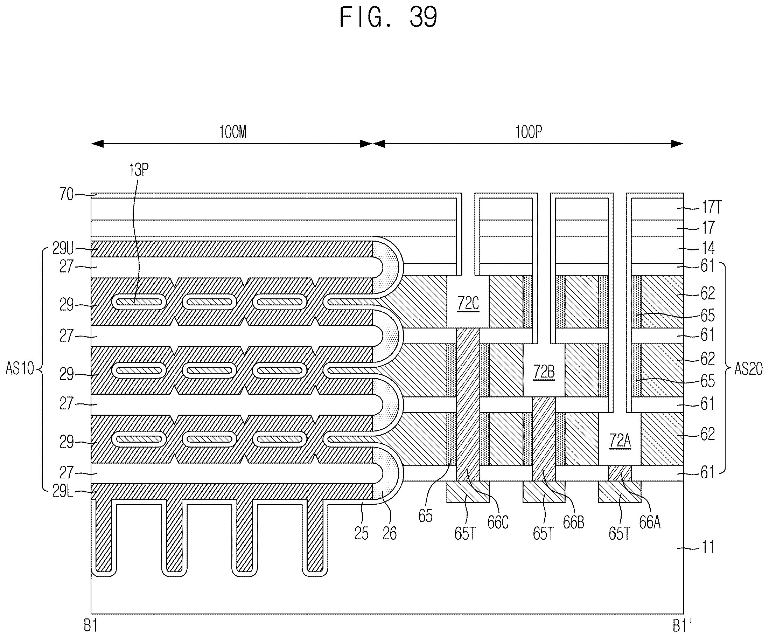

As illustrated in FIG. 39, exposed portions of the contact spacers 65 at the respective levels may be removed. Accordingly, first to third plug openings 72A, 72B and 72C may be formed to expose the first to third sacrificial plug patterns 66A, 66B and 66C. The first plug opening 72A may expose the first sacrificial plug pattern 66A, the second plug opening 72B may expose the second sacrificial plug pattern 66B, and the third plug opening 72C may expose the third sacrificial plug pattern 66C.

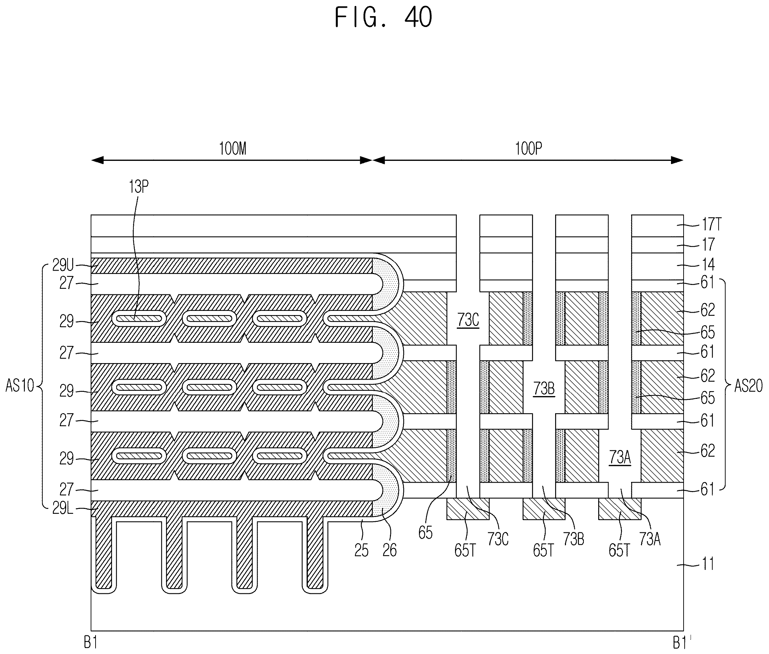

As illustrated in FIG. 40, the remaining first to third sacrificial plug patterns 66A, 66B and 66C may be removed to form first to third contact holes 73A, 73B and 73C. The first to third contact holes 73A, 73B and 73C refer to structures in which the first to third plug openings 72A, 72B and 72C of FIG. 39 are expanded. The first to third contact holes 73A, 73B and 73C may have the same vertical height and may expose the sacrificial pad sheets 62 for each level. For example, the first contact hole 73A may expose the sacrificial pad sheet 62 at the lowest level, the third contact hole 73C may expose the sacrificial pad sheet 62 at the highest level, and the second contact hole 73B may expose the sacrificial pad sheet 62 at the middle level.

Subsequently, the contact liner layer 70 may be removed.

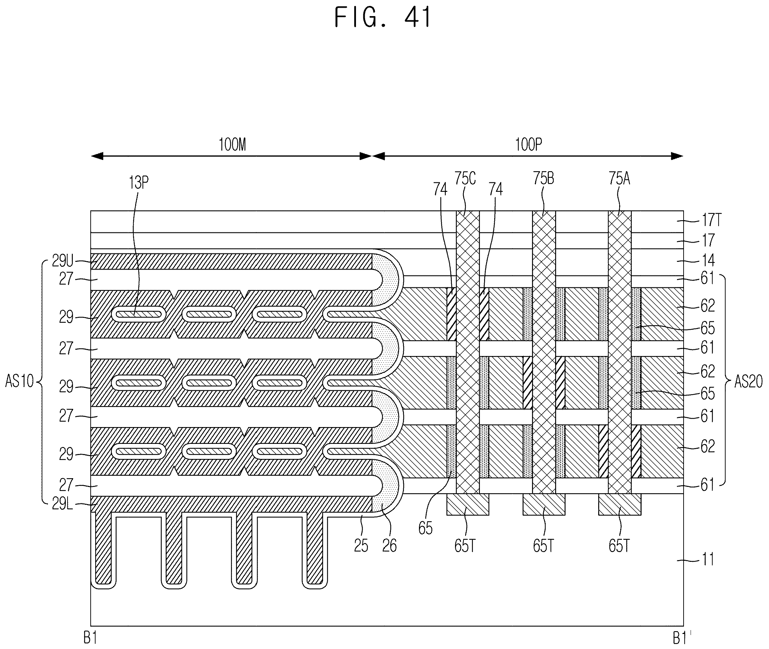

As illustrated in FIG. 41, polysilicon spacers 74 and first to third contact plugs 75A, 75B and 75C may be formed in the first to third contact holes 73A, 73B and 73C. The polysilicon spacers 74 may contact the sacrificial pad sheets 62 at respective levels. The first to third contact plugs 75A, 75B and 75C may fill the first to third pad contact holes 73A, 73B and 73C. The first to third contact plugs 75A, 75B and 75C may have the same height.

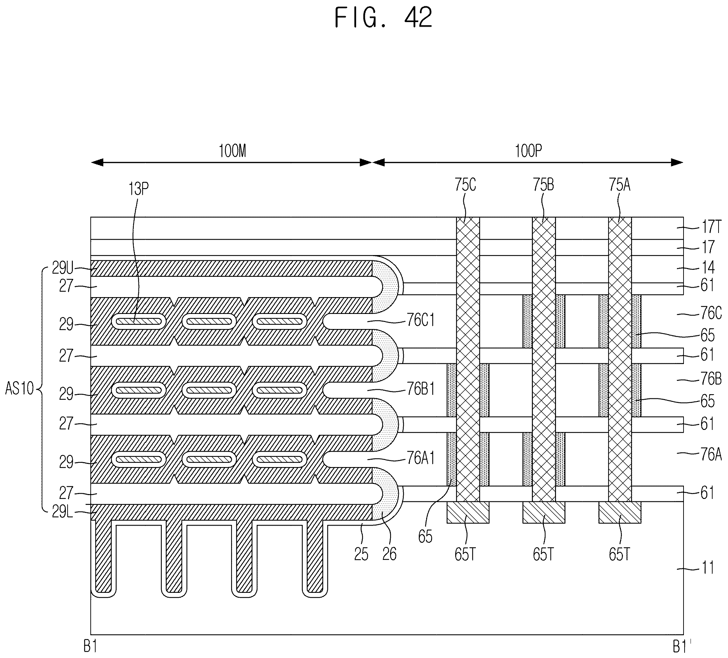

As illustrated in FIG. 42, the sacrificial pad sheets 62 may be removed through the inter-pad isolation trenches of FIG. 24. Accordingly, multi-layer level pad openings 76A, 76B and 76C may be formed. The first pad opening 76A may expose an outer wall of the first contact plug 75A, and outer walls of the second and third contact plugs 75B and 75C may be covered by the contact spacers 65. The second pad opening 76B may expose an outer wall of the second contact plug 75B, and outer walls of the first and third contact plugs 75A and 75C may be covered by the contact spacers 65. The third pad opening 76C may expose an outer wall of the third contact plug 75C, and outer walls of the first and second contact plugs 75A and 75B may be covered by the contact spacers 65. The polysilicon spacers 74 may be removed after or while the sacrificial pad sheets 62 are removed.

Subsequently, the nano sheet dielectric layer 25 may be removed through the pad openings 76A, 76B and 76C, and inner spaces 76A1, 76B1 and 76C1 of extension portions of the horizontal conductive lines 29 may be exposed.

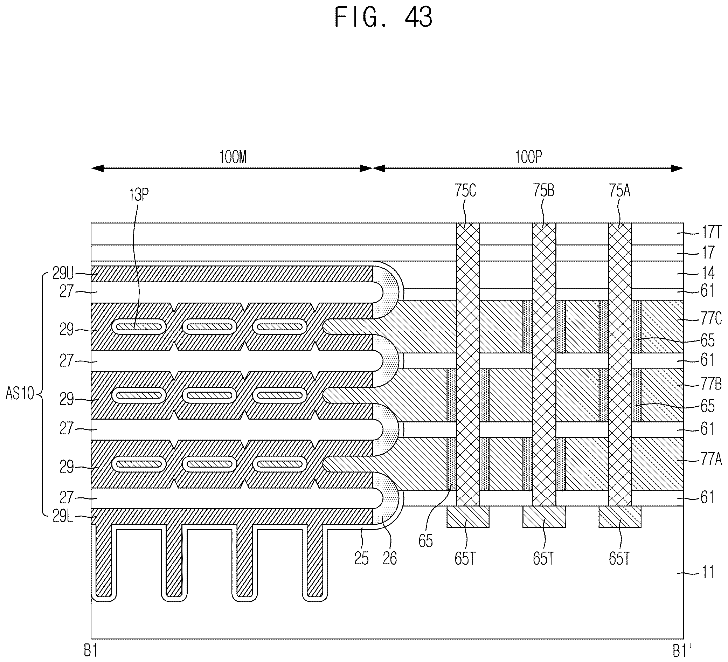

As illustrated in FIG. 43, pads 77A, 77B and 77C may be formed to fill the pad openings 76A, 76B and 76C. The pads 77A, 77B and 77C may be electrically coupled to the extension portions of the horizontal conductive lines 29.

As described above, the contact plugs 75A, 75B and 75C may be formed, and then the pads 77A, 77B and 77C may be formed.

As described above, the coupling region 100P may be formed to have the step-less structure, using the undoped polysilicon and impurity doping to form the pads 77A, 77B and 77C therein. Accordingly, a pitch of the coupling region 100P may be reduced.

In addition, because an area of the coupling region 100P may be reduced, mass production of three-dimensional memory cells may be secured.

According to various embodiments of the present disclosure, it is possible to reduce an area of a coupling region because the coupling region is formed to have a step-less structure, using undoped polysilicon and impurity doping.

While the embodiments of the present disclosure have been illustrated and described with respect to specific embodiments and drawings, the disclosed embodiments are not intended to be restrictive. Further, it is noted that the embodiments may be achieved in various ways through substitution, change, and modification, as those skilled in the art will recognize in light of the present disclosure, without departing from the spirit and/or scope of the present disclosure and the following claims. Furthermore, the embodiments may be combined to form additional embodiments.

## Claims

1. A method for fabricating a semiconductor device, the method comprising:
forming an alternating stack of sacrificial pad sheets and inter-pad dielectric layers, which are stacked vertically spaced apart from each other over a substrate;
forming preliminary contact holes penetrating the alternating stack;
forming sacrificial plugs filling the preliminary contact holes;
performing post-treatment processes on the sacrificial plugs and forming sacrificial plug patterns having different heights and sacrificial recesses having different depths;
forming contact liner layers on sidewalls of the sacrificial recesses;
removing the sacrificial plug patterns and forming contact holes;
forming contact plugs filling the contact holes;
removing the sacrificial pad sheets and forming pad openings; and
forming each pad of a plurality of pads in a different one of the pad openings.

2. The method of claim 1, wherein the post-treatment processes include:
performing impurity doping processes to form sacrificial doping portions on upper portions of the sacrificial plugs; and
performing recess processes to remove the sacrificial doping portions.

3. The method of claim 1, wherein the sacrificial plugs each include undoped polysilicon.

4. The method of claim 1, wherein the sacrificial pad sheets each include monocrystalline silicon.

5. A method for fabricating a semiconductor device, the method comprising:
forming a first alternating stack including horizontal conductive lines over a substrate;
forming a second alternating stack of sacrificial pad sheets and inter-pad dielectric layers, the second alternating stack being horizontally spaced apart from the first alternating stack;
forming preliminary contact holes penetrating the second alternating stack;
forming sacrificial plugs filling the preliminary contact holes;
performing post-treatment processes on the sacrificial plugs and forming sacrificial plug patterns having different heights and sacrificial recesses having different depths;
forming contact liner layers on sidewalls of the sacrificial recesses;
removing the sacrificial plug patterns and forming contact holes;
forming contact plugs filling the contact holes;
removing the sacrificial pad sheets and forming pad openings that expose ends of the horizontal conductive lines; and
forming pads each coupled to a different one of the horizontal conductive lines in the pad openings.

6. The method of claim 5, wherein the post-treatment processes include:
performing impurity doping processes to form sacrificial doping portions on upper portions of the sacrificial plugs; and
performing recess processes to remove the sacrificial doping portions.

7. The method of claim 6, wherein the sacrificial plugs each include undoped polysilicon.

8. The method of claim 6, wherein the sacrificial pad sheets each include monocrystalline silicon.

9. The method of claim 6, wherein forming the first alternating stack including the horizontal conductive lines includes:
forming nano sheet target layers, which are stacked vertically spaced apart from each other, over the substrate;
forming flat plate-shaped sheets that trim first portions of the nano sheet target layers; and
forming extended horizontal conductive lines while surrounding the flat plate-shaped sheets.

10. The method of claim 9, further comprising:
after forming the horizontal conductive lines,
forming a vertical conductive line coupled in common to the flat plate-shaped sheets;
horizontally recessing second portions of the nano sheet target layers and forming fan-shaped sheets;
selectively growing contact nodes on side surfaces of the fan-shaped sheets; and
forming data storage elements each coupled to a different one of the contact nodes.

11. A semiconductor device comprising:
a lower structure;
a cell array region including a plurality of horizontal conductive lines each having a gate-all-around structure, which are vertically stacked in a first direction over the lower structure;
a coupling region including a stack of a plurality of pads each coupled to a different one of the horizontal conductive lines and having the same horizontal length; and
a plurality of contact structures coupled to the pads.

12. The semiconductor device of claim 11, wherein each of the contact structures includes:
a plurality of contact plugs penetrating the stack of the pads; and
contact spacers disposed on sidewalls of the pads and the contact plugs,
wherein the pads are electrically coupled to the contact plugs for each level.

13. The semiconductor device of claim 11, wherein each of the horizontal conductive lines include an extension portion extending to the coupling region, and the extension portion has an inner space.

14. The semiconductor device of claim 13, wherein the pads include edge portions electrically coupled to the extension portions of the horizontal conductive lines, and the edge portions of the pads are disposed in the inner spaces of the extension portions of the horizontal conductive lines.

15. The semiconductor device of claim 11, wherein the cell array region further includes:
a plurality of nano sheets disposed at the same horizontal level;
a vertical conductive line coupled to one side of the nano sheets; and
data storage elements each coupled to the other side of the nano sheets,
wherein each of the horizontal conductive lines surrounds the nano sheets at the same horizontal level.
